(19) Europäisches Patentamt
European Patent Office
Office européen des brevets

(11) EP 2 490 262 B1

(12) # EUROPEAN PATENT SPECIFICATION

(45) Date of publication and mention of the grant of the patent:
**26.11.2014 Bulletin 2014/48**

(51) Int Cl.:
***H01L 27/146*** *(2006.01)*
***C09J 4/00*** *(2006.01)*
***G03F 7/00*** *(2006.01)*
***G03F 7/09*** *(2006.01)*
***G03F 7/105*** *(2006.01)*

(21) Application number: **12153292.3**

(22) Date of filing: **31.01.2012**

(54) **Light-shielding film, method of producing the same and solid-state imaging device**

Leichtabschirmender Film, Verfahren zu dessen Herstellung und Festzustand-Abbildungsvorrichtung

Film protecteur contre la lumière, son procédé de fabrication et dispositif d'imagerie à l'état solide

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.02.2011 JP 2011031284**

(43) Date of publication of application:
**22.08.2012 Bulletin 2012/34**

(73) Proprietor: **Fujifilm Corporation**
**Minato-ku**
**Tokyo (JP)**

(72) Inventors:
- **Muro, Naotsugu**
**Shizuoka-ken (JP)**
- **Murayama, Satoru**
**Shizuoka-ken (JP)**
- **Kubota, Makoto**
**Shizuoka-ken (JP)**

(74) Representative: **Hoffmann Eitle**
**Patent- und Rechtsanwälte PartmbB**
**Arabellastraße 30**
**81925 München (DE)**

(56) References cited:
**JP-A- 2007 043 628**
**JP-A- 2009 117 454**
**JP-A- 2010 045 191**
**US-A1- 2010 025 710**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 490 262 B1

Printed by Jouve, 75001 PARIS (FR)

## Description

BACKGROUND OF THE INVENTION

### Technical Field

The present invention relates to a light-shielding film that contains a black pigment such as titanium black, a method of producing the same, and a solid-state imaging device.

### Related Art

Solid-state imaging devices such as CCD (charge coupled device) or CMOS (Complementary Metal-Oxide Semiconductor) have a light-shielding film in order to prevent noise, improve the image quality etc.

As a composition for forming a light-shielding film for solid-state imaging devices, a radiation-sensitive composition that contains a black colorant, such as carbon black or titanium black, has been known.

Specifically, for the purpose of improving the optical density etc., a radiation-sensitive composition that contains titanium black and has a specific X-ray diffraction peak intensity ratio (see, for example, Japanese Patent No. 3724269 and International Publication No. WO 2005/037926) and a radiation-sensitive composition that contains titanium black having a specific nitrogen concentration and a specific crystallite diameter (see, for example, JP-A No. 2006-182627, JP-A No. 2006-206891 and JP-A No. 2006-209102) have been studied.

Further, for the purpose of obtaining a high light-shielding property with a small thickness, a composition for forming a light-shielding film that contains titanium black and a resin component (see for example, JP-A No. 2007-115921) has been disclosed.

JP 2010045191 is another prior-art disclosing a radiation sensitive composition for forming a light shielding film for a solid-state image sensor.

In recent years, associated with a reduction in size or thickness, and with an increase in sensitivity of solid-state imaging devices, there has been an increasing demand for a silicon substrate having a solid-state imaging portion at one side to prevent transmission of visible light to a region other than an area for forming a solid-state imaging device and prevent noises caused by light reflection.

A silicon substrate, which is a support for a solid-state imaging device, exhibits a high transmission with respect to visible light. Further, an imaging device, which is provided to the solid-state imaging device, exhibits a high sensitivity with respect to visible light. Therefore, preventing light reflection not only from at an incident place but also at side surfaces has become important in order to achieve a high resolution.

In addition, as the shape of a solid-state imaging device becomes complicated, there has been demand for forming a light-shielding film not only to a conventional plane surface, i.e., a plane that is horizontal with respect to a direction of gravitational force, but also to a plane positioned at an angle with a horizontal plane, such as a side surface of a support, in order to reduce noises by preventing not only visible light but also reflection light.

Conventionally, a light-shielding film is formed by spin coating etc. on a plane surface on which a wafer level lens or a imaging device is formed, or on the back side. However, in a case in which an imaging device is formed inside a unit, a new coating method is desired in order to form a light-shielding film not only on a plane surface but also on a side surface.

However, since conventional radiation-sensitive compositions for forming a light-shielding film are supposed to be used in a spin coating method, and supposed to be applied onto a surface having small unevenness, there has been demand for a composition that can form a light-shielding film efficiently not only on a plane surface but also on a plane at an angle with a plane surface, such as side surfaces of a unit.

The invention has been made in view of the above circumstances, and aims to achieve the following objectives.

An objective of the invention is to provide a light-shielding film that can be readily formed not only on a plane surface but also on a surface at an angle with a plane surface, such as side surfaces, and can shield visible light and suppress reflection of visible light.

Another objective of the invention is to provide a method of a light-shielding film that can favorably shield visible light and suppress reflection of visible light.

Yet another objective of the invention is to provide a solid-state imaging device having a light-shielding film obtained by the method as set forth above, in which transmission or reflection of visible light is suppressed.

### Means for Solving the Problem

The invention provides a light shielding film, a method of manufacturing a light shielding film and a solid-state imaging device comprising such a light shielding film as defined in claims 1, 9 and 15, respectively.

Effect of the Invention

According to the invention, it is possible to provide a light-shielding film that can be readily formed not only on a plane surface but also on a surface positioned at an angle with the plane surface, and can shield visible light and suppress reflection of visible light.

Further, according to the invention, it is possible to provide a method of producing a light-shielding film that exhibits a favorable visible light-shielding property and a favorable visible light-antireflection property, and a solid-state imaging sensor having a light-shielding film produced by the method, in which generation of noises caused by visible light is suppressed.

BRIEF DESCRIPTION OF THE DRAWINGS

Exemplary embodiments of the invention will be described in detail based on the following figures, wherein:

Fig. 1 is a schematic sectional view of an exemplary embodiment of a support having a light-shielding film according to the invention formed thereon;

Fig. 2 is a schematic sectional view of an exemplary embodiment of the structure of a camera module having an exemplary embodiment of a solid-state imaging device according to the invention; and

Fig. 3 is a schematic sectional view of an exemplary embodiment of a solid-state imaging device according to the invention.

DETAILED DESCRIPTION OF THE INVENTION

«Light-shielding Film for Solid-state Imaging Device»

The light-shielding film for a solid-state imaging device of the invention is a light-shielding film for a solid-state imaging device, the solid-state imaging device having, on at least one surface of a substrate, an imaging device unit having a light-receiving element, and a wall formed on the at least one surface of the substrate on which the imaging device unit is formed,

the light-shielding film being formed by spraying, on the at least one surface of the silicon substrate on which the light-receiving element is formed and on the wall formed on the at least one surface of the silicon substrate on which the light-receiving element is formed, a radiation-sensitive composition including: (A) a pigment dispersion comprising a dispersed material comprising a black pigment, a dispersant, and an organic solvent, 90% of the dispersed material having a particle diameter of from 15 nm to 30 nm; (B) a polymerizable compound; and (C) a polymerization initiator.

The substrate on which the light-shielding film of the invention is to be formed is a substrate having a wall 114 formed on a flat bottom 112 on which an imaging device unit (not shown) is formed. Fig 1 is a schematic sectional view showing an exemplary embodiment of the substrate 110. In this embodiment, the wall 114 is formed at an end of the flat bottom 112 such that the angle between the wall 114 and the flat bottom 112 (the angle indicated by $\alpha$ in Fig. 1) is 90°. The angle between the wall 114 and the flat bottom 1 12 is not limited to 90° and may be any angle of more than 0° to less than 180°. However, in particular, when the light-shielding film is formed on the wall that is approximately vertical to the flat bottom, specifically when the angle $\alpha$ is from 45° to 135°, especially approximately 90°, the effect of the invention is more remarkable on the point that a uniform light-shielding film can be formed by a single coating process. The wall 114 provided on the flat bottom 112 of the substrate constitutes, for example, a lateral side of a lens holder in which an imaging lens is placed, a partition wall formed between light-receiving element units, or an upper wall that faces the light-receiving element side of the substrate.

The radiation-sensitive composition used for the formation of the light-shielding film of the invention is compatible with a spray coating method, since the dispersed material including a black pigment has a small size and thus favorably disperses. From the viewpoint of improving the compatibility with a spray coating method, the radiation-sensitive composition preferably has a viscosity at 25 °C of from 2 mPa·s to 50 mPa·s. In the present specification, the viscosity at 25 °C refers to a value measured with an E type viscometer. The viscosity at 25 °C is more preferably from 5 mPa·s to 40 mPa·s.

Regarding the spray coating method, from the viewpoint of preventing the nozzle from clogging during spray coating, the viscosity of the composition during spray coating is preferably 15 mPa·s or less. Further, in a case in which the radiation-sensitive composition is applied by spray coating onto a surface that is not horizontal, for example, a vertical surface or the like, the viscosity of the composition is preferably 4 mPa·s or more from the viewpoint of forming a uniform coating film without dripping.

The viscosity may be controlled by, for example, changing or adjusting the type or the amount of the binder polymer, the type or the amount of the solvent, and the solid content concentration of the radiation-sensitive composition,

or by adding a thickener.

Examples of the conditions for the radiation-sensitive composition that is highly compatible with a spray coating method include that 90% or more of the dispersed material including a black pigment has a particle size of from 15 nm to 30 nm and that the dispersed material exhibits favorable dispersibility.

The spray coating may be carried out by a known spray coating method and a known spray device.

In the present invention, the term "infrared" refers to a wavelength range of from 700 nm to 1200 nm, and the term "visible light" refers to a wavelength range of from 400 nm to 800 nm.

Further, the expression "shields infrared light or visible light" refers to a state in which the transmission with respect to light of the whole wavelength range as mentioned above is 10% or less. Further, the expression "prevents (suppresses) reflection in the visible range" refers to a state in which the reflectance at the surface with respect to light of a wavelength range of approximately 450 nm is 1% or less. The reflectance may be measured by a method as described below.

In the present specification, the imaging device unit refers to a region in which plural imaging devices (CCD, CMOS or the like) are arranged (for example, in a matrix form).

In the present specification, the silicon substrate provided with an imaging device unit is also referred to as "a solid-state imaging device" or "a solid-state imaging device substrate". The solid-state imaging device may include other elements (such as a color filter or a microlens) formed therein.

In the following, the components of the radiation-sensitive composition used for forming a light-shielding film of the present invention are described.

<(A) Pigment dispersion including dispersed material containing black pigment, dispersant and organic solvent, 90% or more of the dispersed material having particle size of from 15 nm to 30 nm>

The pigment dispersion in the invention includes a dispersed material containing a black pigment such as titanium black particles.

(a-1) Black pigment

The black pigment may be used without any particular restriction, as long as it has an absorption with respect light of a wide wavelength range, and it may be a known black pigment useful for forming a light-shielding film. Preferable examples of the black pigment that is favorably used in the present invention include the following materials that exhibits an absorbance as described below.

Specifically, a film having a thickness of 2.5 μm is formed on a glass substrate from a pigment dispersion prepared by dispersing a pigment to be evaluated in an organic solvent. Then, the film is pre-baked at 90°C for 120 seconds to evaporate the organic solvent, thereby forming a pigment-containing film (dried film). The absorption of the film with respect to light at a wavelength of 740 nm is measured, and the absorbance (ABS) is obtained.

A calculational value of absorbance ABS (r), which is a value of a film having a thickness of 2.5 μm formed from the pigment alone, is obtained from the measured value of the ABS, by calculating the weight ratio of the pigment and the dispersant, and the volume ratio of the pigment and the dispersant from their specific gravity. When the pigment exhibits the value of ABS (r) of 1.0 or more, it is regarded that the pigment has a light-shielding property with respect to visible light that reaches a sufficient level for forming a light-shielding film of the invention.

Examples of such black pigment include titanium black (ABS (r) = 11.0), carbon black (ABS (r) = 10.4), and cesium tungsten oxide (ABS (r) = 1.1). The black pigment preferably includes titanium black particles.

The pigment dispersion contains a black pigment. The black pigment is contained, as a dispersed material, in the dispersion composition, and 90% or more of the dispersed material has a particle size of from 15 nm to 30 nm.

Preferable embodiments of the black pigment include titanium black particles. It is particularly preferable that the dispersed material contains titanium black particles and Si atoms, and the content ratio of Si atoms to Ti atoms (Si/Ti) in the dispersed material is preferably in the range of from 0.2 to 0.5.

In the present invention, the term "a dispersed material containing a black pigment" encompasses black pigments in the form of primary particles and black pigments in the form of aggregates (secondary particles).

The particle size of the dispersed material in the invention refers to a particle diameter of the dispersed material. The particle diameter refers to a diameter of a circle whose area is equivalent to a projected area of an external surface of the particle. The projected area of a particle is calculated by measuring the area by electron microscope photography, and correcting the magnification thereof.

In the light-shielding film of the invention, 90% or more of the dispersed material, which is contained in a cured film (light-shielding film) obtained by curing the radiation-sensitive composition, also has a particle size of from 15 nm to 30 nm.

In the invention, since 90% or more of the dispersed material containing a black pigment has a particle size of

from 15 nm to 30 nm, occurrence of nozzle clogging during spray coating can be suppressed, and a light-shielding film having a uniform thickness can be formed. Further, by controlling the particle size to be within the above-described range, the amount of residues formed at an unexposed area during pattern formation can be reduced. The reason for this is assumed to be that absorption or scattering of radiation rays used for curing the light-shielding film is reduced as a result of controlling the particle size to a certain range, and that the dispersed material having a small particle size contributes to improvement in the removability of the uncured radiation-sensitive composition (especially titanium black particles) at the time of forming the light-shielding film. In the present specification, the definition of residue includes a component derived from a black pigment such as titanium black, a resin component or the like contained in the radiation-sensitive composition.

As the black pigment used in the invention, titanium black particles are preferable. This is because titanium black particles exhibit an excellent light-shielding property with respect to light of wavelengths over a wide range of from ultraviolet light to infrared light, especially exhibit an excellent light-shielding property with respect to infrared light (infrared light-shielding property), in addition to visible light.

In order to determine whether or not a dispersed material, contained in a pigment dispersion or a radiation-sensitive composition, includes a dispersed material having a particle size of from 15 nm to 30 nm in an amount of 90% or more, the following method (1) can be used.

In order to determine whether or not the dispersed material, contained in a cured film (light-shielding film) obtained by curing the radiation-sensitive composition, includes a dispersed material having a particle size of from 15 nm to 30 nm in an amount of 90% or more, the following method (2) can be used.

< Method (1)>

A titanium black dispersion or a radiation-sensitive composition is diluted 500 times with propyleneglycol monomethylether acetate (hereinafter, also abbreviated as PGMEA), and the resultant liquid is dropped on a carbon thin film and dried. A photograph is taken with a transmission electron microscope, and the projected area of the external surface of 400 particles is measured from the photograph. Then, the diameter of a circle that is equivalent to the obtained projected area is calculated, and a frequency distribution is evaluated therefrom.

< Method (2)>

A photograph and an element map of Ti and Si of a cross section of a substrate, on which a light-shielding film is formed, are taken with a scanning electron microscope (S-3400N, trade name, manufactured by Hitachi High-Technologies Corporation) and an energy dispersive X-ray analyzer (GENESIS, trade name, manufactured by AMETEK, Inc.). The projected area of the external surface of 400 particles, in which Ti elements are detected, is measured from the obtained photograph. Then, the diameter of a circle that is equivalent to the obtained projected area is calculated, and a frequency distribution is evaluated therefrom.

In the following, details of the titanium black particles are described.

The titanium black particles in the present invention refer to black particles including titanium atoms, and low-order titanium oxide, titanium oxynitride, and the like are preferred.

Titanium black may be used as it is, but may be surface-modified if needed, for the purpose of improving dispersibility, suppressing aggregability, and the like. Examples of the surface modification method include a method of coating with silicon oxide, titanium oxide, germanium oxide, aluminum oxide, magnesium oxide, zirconium oxide, or the like. It is also possible to carry out a surface treatment with a water-repellent material, such as those described in JP-A No. 2007-302836.

Examples of the commercially available product of titanium black include TITANIUM BLACK 10S, 12S, 13R, 13M, 13M-C, 13R, 13R-N, 13M-T (trade names, all manufactured by Mitsubishi Materials Electronic Chemicals Co., Ltd.), and TILACK D (trade name, manufactured by Ako Kasei Co., Ltd.)

Examples of a method for manufacturing titanium black include a method in which a mixture of titanium dioxide and metallic titanium is heated in a reduction atmosphere, thereby carrying out reduction (a method described in JP-A No. 49-5432), a method in which ultrafine titanium dioxide obtained by high-temperature hydrolysis of titanium tetrachloride is reduced in a hydrogen-containing reduction atmosphere (a method described in JP-A No. 57-205322), a method in which titanium dioxide or titanium hydroxide is reduced at high temperature in the presence of ammonia (a method described in JP-A Nos. 60-65069 and 61-201610), and a method in which a vanadium compound is deposited onto titanium dioxide or titanium hydroxide, and high-temperature reduction is carried out in the presence of ammonia (a method described in JP-A No. 61-201610). However, the method is not limited to these examples.

The titanium black particles used in the present invention preferably have a small primary particle diameter.

The pigment dispersion used in the present invention may contain only titanium black particles as a dispersed material, or may contain two or more kinds of pigments, including another black pigment and/or a pigment having a different color for the purpose of ajusting the absorption.

Furthermore, the dispersed material may be a combination of titanium black particles with one or more kinds of black pigments including, for example, composite oxides of Cu, Fe, Mn, V, Ni, or the like, cobalt oxide, iron oxide, carbon black or aniline black, for the purpose of adjusting dispersibility, coloration properties, or the like. In that case, the dispersed material preferably includes titanium black particles in an amount of 50% by mass or more of the dispersed material.

Further, it is preferable that the dispersed material contains titanium black particles and Si atoms, and the content ratio of Si atoms to Ti atoms in the dispersed material is in a range of from 0.20 to 0.50.

In order to adjust the ratio Si/Ti of the dispersed material to a range of from 0.20 to 0.50, the following means can be used.

For example, titanium oxide and silica particles are mixed at a proportion of, for example, 12.5 g of silica particles with respect to 100 g of titanium oxide, and are dispersed with a dispersing machine to obtain a dispersion composition. The obtained dispersion composition is subjected to a reduction treatment at high temperature (for example, 850°C to 1000 °C), whereby a dispersed material that contains titanium black particles as a primary component, in which the ratio of Si to Ti is in the range described above, is obtained. In this process, it is not possible to obtain a dispersed material containing Si and Ti that exerts the effects of the present invention by simply mixing titanium black that has already been subjected to a reduction treatment and silica particles.

The dispersed material having the above-described ratio of Si/Ti may be prepared in a manner analogous to the methods described in item (6) of paragraph [0005] of JP-A No. 2008-26604, and paragraphs [0016] to [0021] of JP-A No. 2008-26604.

The radiation-sensitive composition contains a dispersed material that includes a black pigment derived from a pigment dispersion. With respect to the dispersed material containing titanium black particles, which are contained in the radiation-sensitive composition or in a cured film (light-shielding film) that is obtained by curing the radiation-sensitive composition, the content ratio (Si/Ti) of Si atoms to Ti atoms in the dispersed material is in a range of from 0.20 to 0.50, and the preferable range is also the same as those described above.

In the present invention, the content ratio (Si/Ti) of Si atoms to Ti atoms in the dispersed material is, as described above, preferably in the range of from 0.20 to 0.50, and more preferably in a range of from 0.35 to 0.45. When the content ratio is within this range, the pigment dispersion can be readily produced. In addition, since the dispersion stability is improved, for example, the pigment dispersion exhibits an excellent spray coating suitability, and since the reduction in sprayability during spray coating caused by sedimentation or aggregation of particles is suppressed, a uniform light-shielding film that exhibits a high light-shielding property can be readily formed not only on a horizontal surface but also on a vertical surface, a curved surface, or an uneven surface.

In addition, when the particle size of the dispersed material is 30 nm or less as described above, spray coating suitability can be further improved. Further, it is estimated that there is an advantage in that an increase of a component containing Si atoms causes an increase in interaction between the dispersed material and a dispersant, which improves developer-resistance of the surface on which a pattern is formed, thereby suppressing the roughness of the pattern-formed surface.

As described later, in order to adjust the light-shielding property or the like, other colorants (organic pigments, dyes, or the like) may be used in combination with a black pigment such as titanium black particles, as long as the effects of the invention are not impaired.

The content of (a-1) black pigment, represented by titanium black particles, in the (A) pigment dispersion is preferably in a range of from 5% by mass to 60% by mass, and more preferably in a range of from 10% by mass to 50% by mass, with respect to the total mass of the dispersion.

Further, the content of (a-1) black pigment in the radiation-sensitive composition is preferably in a range of from 2.5% by mass to 30% by mass, and more preferably in a range of from 5% by mass to 20% by mass, with respect to a total mass of the radiation-sensitive composition.

(a-2) Dispersant

The (A) pigment dispersion or the radiation-sensitive composition contains (a-2) a dispersant.

Examples of the dispersant include a polymer dispersant (for example, polyamide amine and a salt thereof, polycarboxylic acid and a salt thereof, a high-molecular weight unsaturated acid ester, a modified polyurethane, a modified polyester, a modified poly(meth)acrylate, (meth)acrylic copolymer, a naphthalene sulfonic acid-formaline condensate), polyoxyethylene alkylphosphoric acid ester, polyoxyethylene alkylamine, alkanolamine, and pigment derivatives.

The dispersant can be further classified into a straight-chain polymer, a terminal-modified polymer, a glaft

polymer, and a block polymer, from the viewpoint of its structure.

The dispersant adsorbs to a surface of a dispersed material such as titanium black particles, or to a surface of a pigment which are optionally used in combination with the titanium black particles, and acts to prevent the dispersed material from reaggregation. Accordingly, preferable examples of the structure of the dispersant include a terminal-modified polymer having an anchor site to the pigment surface, a glaft polymer, and a block polymer.

In addition, the dispersant in the present invention exerts an effect of promoting absorption of a dispersing resin by modifying the surface of the dispersed material.

Specific examples of the dispersant that can be used in the present invention include: DISPER BYK-101 (trade name, polyamide amine phosphate), 107 (trade name, carboxylic acid ester), 110 (trade name, copolymer containing an acid group), 130 (trade name, polyamide), 161, 162, 163, 164, 165, 166, 170, 180 (all trade names, high-molecular copolymer), BYK-P104 and P105 (all trade names, high-molecular weight unsaturated polycarboxylic acid), which are manufactured by BYK Chemie GmbH; EFKA 4047, 4050, 4010, 4165 (all trade names, polyurethanes), EFKA 4330, 4340 (all trade names, blockcopolymer), 4400, 4402 (all trade names, modified polyacrylate), 5010 (trade name, polyester amide), 5765 (trade name, high-molecular weight polycarboxylic acid salt), 6220 (trade name, fatty acid polyester), 6745 (trade name, phthalocyanine derivative), and 6750

(trade name, azo pigment derivative), which are manufactured by EFKA Chemicals; AJISPER PB821, PB822 (all trade names), all manufactured by Ajinomoto Fine-Techno Co., Ltd.; FLORENE TG-710 (trade name, urethane oligomer), POLYFLOW No. 50E and No. 300 (all trade names, acrylic copolymer), which are manufactured by KYOEISHA CHEMICAL Co., LTD.; DISPARLON KS-860, 873SN, 874, #2150 (all trade names, aliphatic polyvalent carboxylic acid), #7004 (trade name, polyether ester), DA-703-50, DA-705, DA-725 (all trade names), which are manufactured by Kusumoto Chemicals, Ltd.; DEMOL RN, N (all trade names, naphthalene sulfonic acid-formaldehyde polycondensatate), MS, C, SN-B (all trade names, aromatic sulfonic acid-formaldehyde polycondensate), HOMOGENOL L-18 (trade name, high-molecular polycarboxylic acid), EMALGEN 920, 930, 935, 985 (all trade names, polyoxyetylene nonylphenylether), and ACETAMINE 86 (trade name, stearylamine acetate); SOLSPERSE 5000 (trade name, phthalocyanine derivative) 22000 (trade name, azo pigment derivative), 13240 (trade name, polyester amine), 3000, 17000, 27000 (all trade names, polymer having a functional group at the terminal), 24000, 28000, 32000, 38500 (all trade names, glaft-type polymer), which are manufactured by Lubrizol Corporation; NIKKOL T106 (trade name, polyoxyethylene sorbitan monoolate), and MYS-IEX (trade name, polyoxyethylene monostearate), all manufactured by Nikko Chemicals Co., Ltd.

Further, an amphoteric dispersant such as HINOACT T-8000 E (trade name) manufactured by Kawaken Fine Chemicals Co., Ltd. may be also used.

These dispersants may be used either singly or in combination of two or more kinds.

The acid value of the dispersant is preferably in a range of from 5.0 mg KOH/g to 200 mg KOH/g, more preferably in a range of from 10 mg KOH/g to 150 mg KOH/g, and still more preferably in a range of from 60 mg KOH/g to 150 mg KOH/g.

If the acid value of the dispersant is 200 mg KOH/g or less, exfoliation of a pattern during development for forming a light-shielding film may be effectively suppressed. If the acid value of the dispersant is 5.0 mg KOH/g or more, alkali developability is further improved. In addition, if the acid value of the dispersant is 60 mg KOH/g or more, sedimentation of titanium black particles may be further suppressed. As a result, the number of coarse particles can be further reduced, whereby the temporal stability of the pigment dispersion or the radiation-sensitive composition may be further improved.

In the present invention, the acid value of the dispersant can be calculated from, for example, an average content of the acid group in the dispersant. Further, a resin having a desired acid value can be obtained by changing the content of a monomer unit having an acid group that is a component of the dispersant.

The weight-average molecular weight of the dispersant in the present invention is preferably in a range of from 10,000 to 300,000, more preferably in a range of from 15,000 to 200,000, still more preferably in a range of from 20,000 to 100,000, and particularly preferably in a range of from 25,000 to 50,000, from the viewpoints of preventing exfoliation of a pattern and improving developability during development for forming a light-shielding film. The weight-average molecular weight of the dispersant can be measured by GPC, for example.

(Graft copolymer)

In the present invention, it is also preferable to use a graft copolymer (hereinafter, also referred to as "a specific resin") as a dispersant. By using a graft copolymer as a dispersant, dispersibility and storage stability can be further improved.

The graft copolymer preferably has a graft chain in which the number of atoms excluding hydrogen atoms is in a range of from 40 to 10000. The graft chain in this case refers to a portion ranging from the base of a copolymer main chain to the end of a group branched off from the copolymer main chain.

The specific resin is a dispersed resin capable of providing dispersibility to titanium black particles, and exhibits

excellent dispersibility and an affinity for a solvent due to the presence of a graft chain. As a result, the specific resin exhibits excellent effects on the dispersibility of titanium black particles and the dispersion stability over time. Further, in the case where a specific resin is used for a radiation-sensitive composition, generation of residues during alkali development is suppressed due to an affinity for a polymerizable compound, other resins or the like may be used in combination.

Further, by introducing an alkali-soluble partial structure such as a carboxyl group into the specific resin, it is possible to provide the specific resin with a function of imparting developability for pattern formation during alkali development.

Accordingly, by introducing an alkali-soluble partial structure into the above-described graft copolymer, the dispersed resin by itself, which is an essential component for dispersing the titanium black particles, exhibits alkali solubility in the pigment dispersion. As a result, the radiation-sensitive composition containing titanium black particles exhibits an excellent light-shielding property at an exposed region, and exhibits improved alkali developability at an unexposed region.

As the length of the graft chain increases, the steric repulsion effect is increased and dispersibility is improved. On the other hand, if the graft chain is too long, adsorption of the graft chain to titanium black is decreased and dispersibility is reduced. Accordingly, in the graft copolymer used in the present invention, the number of atoms excluding hydrogen atoms per graft chain is preferably in a range of from 40 to 10000, more preferably in a range of from 50 to 2000, and still more preferably in a range of from 60 to 500.

Examples of a polymer structure of the graft chain include poly (meth)acryl, polyester, polyurethane, polyurea, polyamide, and polyether. The graft chain is preferably a graft chain having a poly (meth)acryl, polyester, or polyether structure, and more preferably a graft chain having a polyester or polyether structure, in order to improve an interactive property between a graft site and a solvent, and thereby enhancing dispersibility.

The structure of a macromonomer having a polymer structure as mentioned above as a graft chain is not particularly limited, as long as it has a substituent capable of reacting with a polymer main chain, and meets the requirements of the present invention. However, a macromomer having a reactive double bonding group is favorably used.

Examples of the commercially available macromonomer that can be favorably used for the synthesis of the specific resin include AA-6 (trade name, manufactured by TOAGOSEI CO., LTD.), AA-10 (trade name, manufactured by TOAGOSEI CO., LTD.), AB-6 (trade name, manufactured by TOAGOSEI CO., LTD.), AS-6 (trade name, manufactured by TOAGOSEI CO., LTD.), AN-6 (trade name, manufactured by TOAGOSEI CO., LTD.), AW-6 (trade name, manufactured by TOAGOSEI CO., LTD.), AA-714 (trade name, manufactured by TOAGOSEI CO., LTD.), AY-707 (trade name, manufactured by TOAGOSEI CO., LTD.), AY-714 (trade name, manufactured by TOAGOSEI CO., LTD.), AK-5 (trade name, manufactured by TOAGOSEI CO., LTD.), AK-30 (trade name, manufactured by TOAGOSEI CO., LTD.), AK-32 (trade name, manufactured by TOAGOSEI CO., LTD.), BLENMER PP-100 (trade name, manufactured by NOF Corporation), BLENMER PP-500 (trade name, manufactured by NOF Corporation), BLENMER PP-800 (trade name, manufactured by NOF Corporation), BLENMER PP-1000 (trade name, manufactured by NOF Corporation), BLENMER 55-PET-800 (trade name, manufactured by NOF Corporation), BLENMER PME-4000 (trade name, manufactured by NOF Corporation), BLENMER PSE-400 (trade name, manufactured by NOF Corporation), BLENMER PSE-1300 (trade name, manufactured by NOF Corporation), BLENMER 43 PAPE-600B (trade name, manufactured by NOF Corporation), and the like. Of these products, AA-6 (trade name, manufactured by TOAGOSEI CO., LTD.), AA-10 (trade name, manufactured by TOAGOSEI CO., LTD.), AB-6 (trade name, manufactured by TOAGOSEI CO., LTD.), AS-6 (trade name, manufactured by TOAGOSEI CO., LTD.), AN-6 (trade name, manufactured by TOAGOSEI CO., LTD.), and BLENMER PME-4000 (trade name, manufactured by NOF Corporation) are preferably used.

The above-described graft copolymer preferably contains at least one of the structural units represented by the following Formulae (1) to (4), and more preferably contains at least one structural unit represented by any one of the following Formula (1A), the following Formula (2A), the following Formula (3A), the following Formula (3B), and the above-described Formula (4).

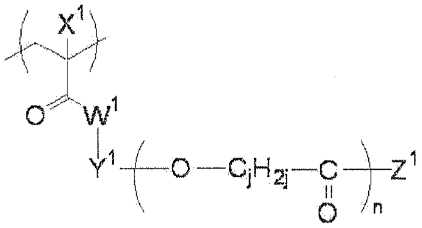
(1)

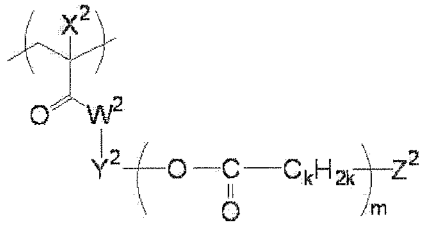
(2)

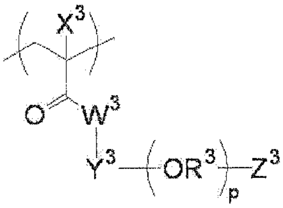
(3)

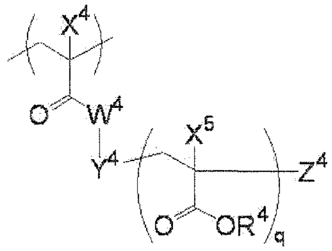
(4)

In Formulae (1) to (4), $W^1$, $W^2$, $W^3$, and $W^4$ each independently represent an oxygen atom or NH. $W^1$, $W^2$, $W^3$, and $W^4$ are preferably an oxygen atom.

In Formulae (1) to (4), $X^1$, $X^2$, $X^3$, $X^4$ and $X^5$ each independently represent a hydrogen atom or a univalent organic group. From the viewpoint of restrictions to synthesis, $X^1$, $X^2$, $X^3$, $X^4$ and $X^5$ each independently are preferably a hydrogen atom or an alkyl group having 1 to 12 carbon atoms, more preferably a hydrogen atom or a methyl group, and still more preferably a methyl group.

In Formulae (1) to (4), $Y^1$, $Y^2$, $Y^3$, and $Y^4$ each independently represent a divalent linking group, and the structure of the divalent linking group is not particularly restricted. Specific examples of the divalent linking group include the following linking groups (Y-1) to (Y-21). In the structures shown below, A and B refer to a bonding site to a terminal group on the left side and a bonding to a terminal group on the right side in Formula (1) to (4), respectively. Among the structures shown below, (Y-2) or (Y-13) is more preferable from a viewpoint of synthetic convenience.

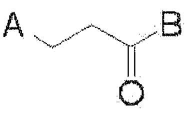
(Y-1)

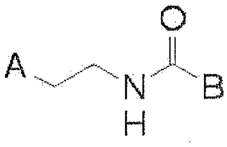
(Y-2)

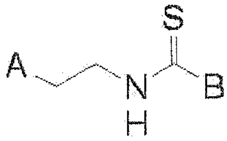
(Y-3)

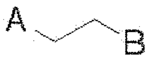
(Y-4)

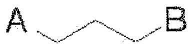
(Y-5)

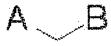
(Y-6)

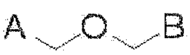
(Y-7)

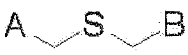
(Y-8)

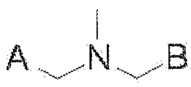
(Y-9)

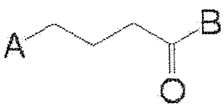
(Y-10)

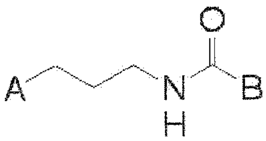
(Y-11)

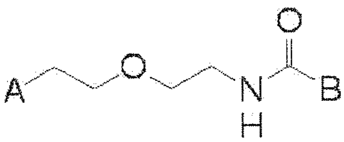
(Y-12)

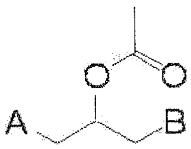

(Y-13)

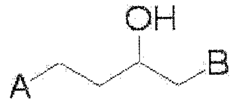

(Y-14)

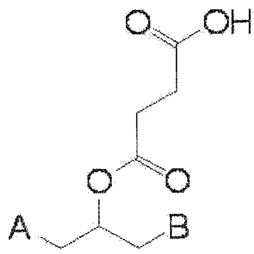

(Y-15)

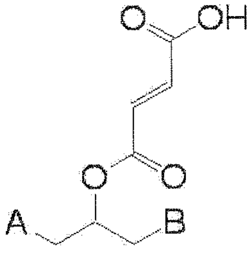

(Y-16)

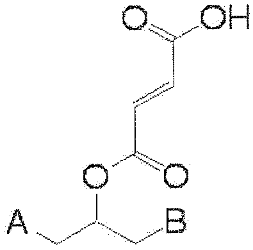

(Y-17)

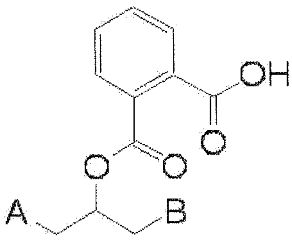

(Y-18)

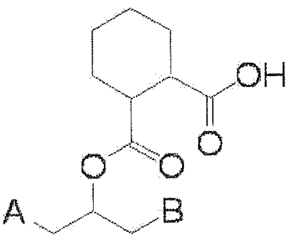

(Y-19)

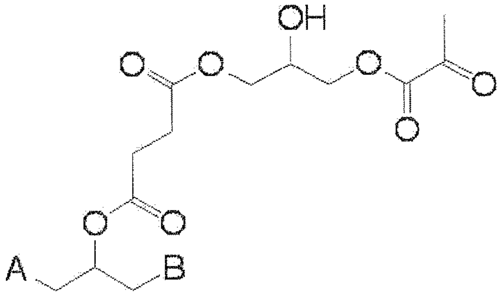

(Y-20)

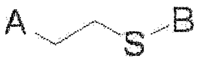

(Y-21)

In Formulae (1) to (4), $Z^1$, $Z^2$, $Z^3$, and $Z^4$ each independently represent a univalent organic group. The structure of the organic group is not restricted in particular, but specific examples of the organic group include an alkyl group, a hydroxyl group, an alkoxy group, an aryloxy group, a heteroaryloxy group, an alkylthioether group, an arylthioether group, a heteroarylthioether group, and an amino group. Among these groups, the organic groups represented by $Z^1$, $Z^2$, $Z^3$, and $Z^4$ are preferably a group that exhibits a steric repulsion effect from the viewpoint of improving dispersibility. The organic groups represented by $Z^1$, $Z^2$, and $Z^3$ each independently are preferably an alkyl group having 5 to 24 carbon atoms, or an alkoxy group having 5 to 24 carbon atoms. Among these groups, an alkoxy group having a branched alkyl group having 5 to 24 carbon atoms, or an alkoxy group having a cycloalkyl group having 5 to 24 carbon atoms are especially preferable. Further, the organic group represented by $Z^4$ is preferably an alkyl group having 5 to 24 carbon atoms, more preferably a branched alkyl group having 5 to 24 carbon atoms or a cycloalkyl group having 5 to 24 carbon atoms.

In Formulae (1) to (4), n, m, p, and q each represent an integer of from 1 to 500.

In Formula (3), when p is an integer of from 2 to 500, the two or more of $R^3$ being present in the graft copolymer may be the same or different from each other. In Formula (4), when q is an integer of from 2 to 500, the two or more of $X^5$ and $R^4$ being present in the graft copolymer may be the same or different from each other.

Further, in Formulae (1) and (2), j and k each independently represent an integer of from 2 to 8. From the viewpoints of dispersion stability and developability, each of j and k in Formulae (1) and (2) is preferably an integer of from 4 to 6, and most preferably 5.

In Formula (3), $R^3$ represents a branched or straight alkylene group, which is preferably an alkylene group having 1 to 10 carbon atoms, and more preferably an alkylene group having 2 or 3 carbon atoms.

In Formula (4), $R^4$ represents a hydrogen atom or a univalent organic group. The structure of the univalent organic group is not particularly restricted. Preferable examples of $R^4$ include a hydrogen atom, an alkyl group, an aryl

group, and a heteroaryl group. A hydrogen atom or an alkyl group is more preferable. When $R^4$ is an alkyl group, the alkyl group is preferably a straight alkyl group having 1 to 20 carbon atoms, a branched alkyl group having 3 to 20 carbon atoms, or a cycloalkyl group having 5 to 20 carbon atoms, more preferably a straight alkyl group having 1 to 20 carbon atoms, and still more preferably a straight alkyl group having 1 to 6 carbon atoms.

In Formula (4), $R^5$ represents a hydrogen atom or a univalent organic group. The structure of the univalent organic group is not particularly restricted. Preferable examples of $R^5$ include a hydrogen atom, an alkyl group, an aryl group, and a heteroaryl group. A hydrogen atom or an alkyl group is more preferable. When $R^5$ is an alkyl group, the alkyl group is preferably a straight alkyl group having 1 to 20 carbon atoms, a branched alkyl group having 3 to 20 carbon atoms, or a cycloalkyl group having 5 to 20 carbon atoms, more preferably a straight alkyl group having 1 to 20 carbon atoms, and still more preferably a straight alkyl group having 1 to 6 carbon atoms.

The specific resin preferably contains a structure unit represented by any one of Formulae (1) to (4) in a range of from 10% to 90% and more preferably in a range of from 30% to 70%, in terms of mass, with respect to the total mass of the specific resin. When the structure unit represented by Formulae (1) to (4) is contained within this range, a high dispersibility of titanium black particles is achieved, and a favorable developability during formation of a light-shielding film is attained.

Further, the specific resin may contain two or more kinds of graft sites whose structures are different from each other.

The structure unit represented by the above-described Formula (1) is more preferably the following Formula (1A) from the viewpoints of dispersion stability and developability.

The structure unit represented by the above-described Formula (2) is more preferably the following Formula (2A) from the viewpoints of dispersion stability and developability.

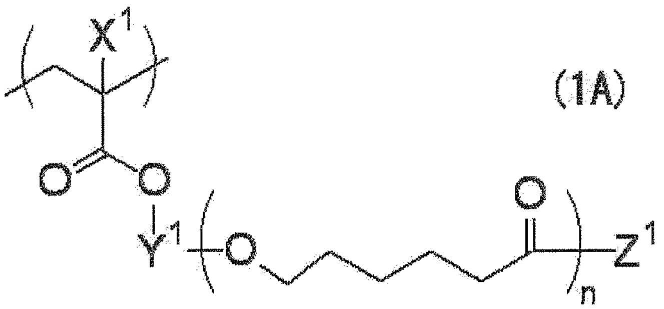

(1A)

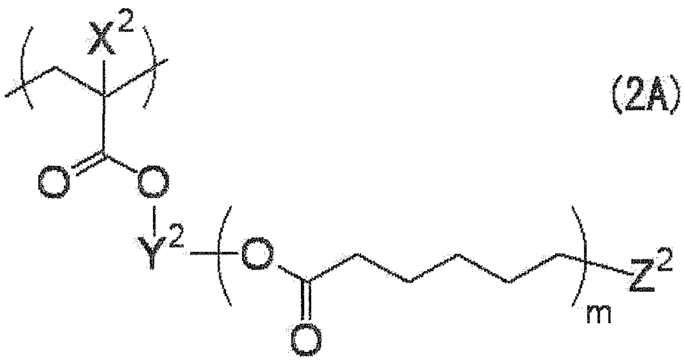

(2A)

In Formula (1A), $X^1$, $Y^1$, $Z^1$ and n each have the same definitions as $X^1$, $Y^1$, $Z^1$ and n in Formula (1), and preferable ranges thereof are also the same.

In Formula (2A), $X^2$, $Y^2$, $Z^2$ and m each have the same definitions as $X^2$, $Y^2$, $Z^2$ and m in Formula (2), and preferable ranges thereof are also the same.

The structure unit represented by the above-described Formula (3) is more preferably the following Formula (3A) or (3B) from the viewpoints of dispersion stability and developability.

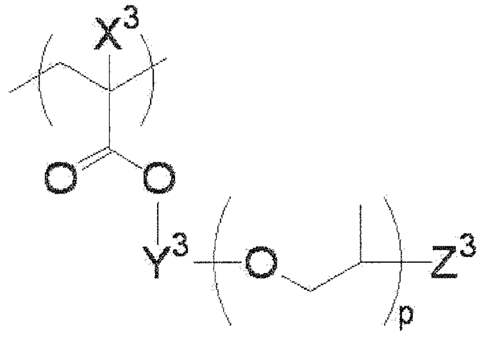

(3A)

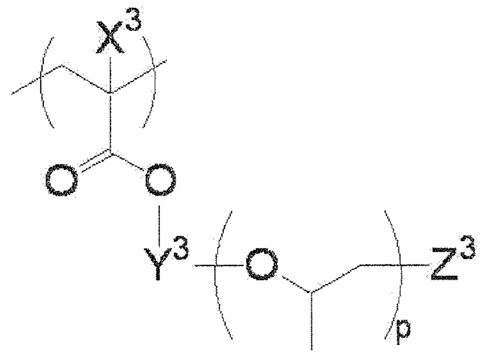

(3B)

In Formula (3A) or (3B), $X^3$, $Y^3$, $Z^3$ and p each have the same definitions as $X^3$, $Y^3$, $Z^3$ and p in Formula (3), and preferable ranges thereof are also the same.

It is more preferable that the specific resin has a structure unit represented by Formula (1A).

A functional group that can interact with a black pigment such as titanium black particles may be introduced into the specific resin at a site other than the graft site. The following description is based on an exemplary embodiment in which titanium black particles, which are preferable as a black pigment, are used, but the invention is not limited thereto.

Examples of the functional group that can interact with titanium black particles include an acid group, a basic group, a coordinating group, and a functional group having reactivity. The functional group may be introduced into the specific resin by utilizing a structure unit having an acid group, a structure unit having a basic group, a structure unit having a coordinating group, or a structure unit having a functional group having reactivity.

Examples of the acid group, which is a functional group capable of interacting with titanium black particles, include a carboxylic acid group, a sulfonic acid group, a phosphoric acid group, and a phenolic hydroxide group. An especially preferable acid group is a carboxylic acid group that exhibits favorable adsorbability to titanium black particles, and disperses the same at high dispersibility. The specific resin may contain one or more kinds of acid groups.

Further, introduction of an acid group may be advantageous in that alkali developability of the specific resin is improved.

The favorable content of the structure unit having an acid group, which is introduced as a copolymerizing component into the specific resin, is in a range of from 0.1 % by mole to 50% by mole. From the viewpoint of suppressing the damage to image strength due to alkali development, the content is more preferably in a range of from 1% by mole to 30%.

Examples of the basic group, which is a functional group capable of interacting with titanium black particles, include a primary amino group, a secondary amino group, a tertiary amino group, a heterocyclic group containing a nitrogen atom, and an amido group. An especially preferable basic group is a tertiary amino group that exhibits favorable adsorption to the pigment and disperses the same with high dispersibility. One or more kinds of a basic group may be introduced into the specific resin.

A favorable content of the structure unit having a basic group, when introduced as a copolymerizing component into the specific resin, is in a range of from 0.01 % by mole to 50% by mole with respect to the total structure units in the specific resin. An especially favorable content is in a range of from 0.01% by mole to 30% by mole from the viewpoint of suppressing inhibition of developability.

Examples of the coordinating group or a group having reactivity, which is a functional group capable of interacting with a black pigment such as titanium black particles, include an acetylacetoxy group, a trialkoxysilyl group, an isocyanate group, an acid anhydride, and an acid chloride. An especially preferable group is an acetylacetoxy group that exhibits favorable adsorption to the pigment and disperses the same with high dispersibility. The specific resin may contain one or more kinds of these groups.

A favorable content of the structure unit having a coordinating group or the structure unit having reactivity, which is introduced as a copolymerizing component into the specific resin, is in a range of from 0.5% by mole to 50% by mole with respect to the total structure units of the specific resin. An especially favorable content is in a range of from 1% by mole to 30% by mole from the viewpoint of suppressing inhibition of developability.

In the case in which the specific resin has a functional group capable of interacting with titanium black particles at a site other than a graft site, the method of introducing the functional group is not particularly restricted as long as the

functional group can interact with titanium black particles. However, the functional group is preferably introduced by utilizing at least one structure unit obtained by a monomer represented by any one of the following Formulae (i) to (iii).

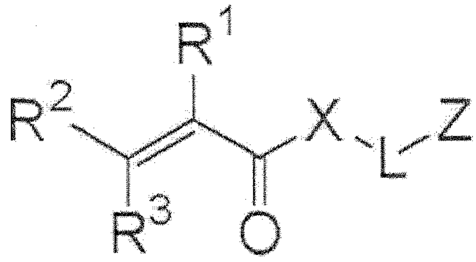

(i)

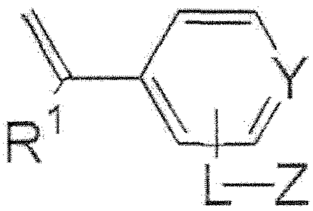

(ii)

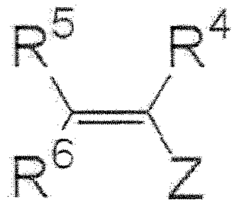

(iii)

In Formulae (i) to (ii), $R^1$, $R^2$, and $R^3$ each independently represent a hydrogen atom, a halogen atom (for example, fluorine, chlorine, bromine, and the like), or an alkyl group having 1 to 6 carbon atoms (for example, methyl, ethyl, propyl, and the like).

$R^1$, $R^2$, and $R^3$, each independently, are more preferably a hydrogen atom, or an alkyl group having 1 to 3 carbon atoms, and are still more preferably a hydrogen atom, or a methyl group. It is especially preferable that $R^2$ and $R^3$ are hydrogen atoms.

X represents an oxygen atom (-O-) or an imino group (-NH-), and preferably an oxygen atom.

In Formulae (i) to (iii), L represents a single bond, or a divalent linking group. Examples of the divalent linking group include a divalent aliphatic group (for example, an alkylene group, a substituted alkylene group, an alkenylene group, a substituted alkenylene group, an alkynylene group, a substituted alkynylene group, and the like), a divalent aromatic group (for example, an arylene group and a substituted arylene group), a divalent heterocyclic group, and a combination of the above-described divalent linking group and at least one selected from an oxygen atom (-O-), a sulfur atom (-S-), an imino group (-NH-), a substituted imino group ($-NR^{31}-$, in which $R^{31}$ represents an aliphatic group, an aromatic group, or a heterocyclic group) or a carbonyl group (-CO-).

The divalent aliphatic group may include a cyclic structure or a branched structure. The number of carbon atoms of the aliphatic group is preferably in a range of from 1 to 20, more preferably in a range of from 1 to 15, and still more preferably in a range of from 1 to 10. The aliphatic group is more preferably a saturated aliphatic group than an unsaturated aliphatic group. The aliphatic group may have a substituent. Examples of the substituent include a halogen atom, a hydroxyl group, an aromatic group, and a heterocyclic group.

The number of carbon atoms of the divalent aromatic group is preferably in a range of from 6 to 20, more preferably in a range of from 6 to 15, and still more preferably in a range of from 6 to 10. Further, the aromatic group may have a substituent. Examples of the substituent include a halogen atom, a hydroxyl group, an aliphatic group, an aromatic group, and a heterocyclic group.

The divalent heterocyclic group preferably includes a 5- or 6-membered ring as a hetero ring. The hetero ring may be condensed with one or more of another hetero ring, an aliphatic ring and an aromatic ring. Further, the heterocyclic group may have a substituent. Examples of the substituent include a halogen atom, a hydroxyl group, an oxo group (=O), a thioxo group (=S), an imino group (=NH), a substituted imino group ($-NR^{32}-$, in which $R^{32}$ represents an aliphatic group, an aromatic group, or a heterocyclic group), an aliphatic group, an aromatic group, and a heterocyclic group.

L is preferably a single bond, an alkylene group, or a divalent linking group including an oxyalkylene structure.

The oxyalkylene structure is more preferably an oxyethylene structure or an oxypropylene structure. Further, L may contain a polyoxyalkylene structure including two or more oxyalkylene structures in a repetitive manner. The polyoxyalkylene structure is preferably a polyoxyethylene structure or a polyoxypropylene structure. The polyoxyethylene structure is represented by $-(OCH_2CH_2)_n-$ in which n is preferably an integer of 2 or more, and more preferably an integer of 2 to 10.

In Formulae (i) to (iii), Z represents a functional group capable of interacting with titanium black, in addition to the graft site. Z is preferably a carboxylic acid group, or a tertiary amino group, and more preferably a carboxylic acid group. Y represents a methine group or a nitrogen atom.

In Formula (iii), $R^4$, $R^5$, and $R^6$ each independently represent a hydrogen atom, a halogen atom (for example, fluorine, chlorine, bromine, and the like), or an alkyl group having 1 to 6 carbon atoms (for example, methyl, ethyl, propyl, and the like), -Z, or -L-Z. L and Z each has the same definitions as L and Z described above, and preferable ranges thereof are also the same.

$R^4$, $R^5$, and $R^6$, each independently, are preferably a hydrogen atom, or an alkyl group having 1 to 3 carbon atoms, and more preferably a hydrogen atom.

In the present invention, a preferred example of the monomer represented by Formula (i) is a compound in which $R^1$, $R^2$ and $R^3$ each independently represent a hydrogen atom or a methyl group; L is a divalent linking group including an alkylene group or an oxyalkylene structure; X is an oxygen atom or an imino group; and Z is a carboxylic acid group.

Further, a preferable example of the monomer represented by Formula (ii) is a compound in which $R^1$ is a hydrogen atom, or a methyl group; L is an alkylene group; Z is a carboxylic acid group; and Y is a methine group. Further, a preferable example of the monomer represented by Formula (iii) is a compound in which $R^4$, $R^5$ and $R^6$ each independently represent a hydrogen atom, or a methyl group; L is a single bond, or an alkylene group; and Z is a carboxylic acid group.

Representative examples of the monomers (compounds) represented by Formulae (i) to (iii) are described below.

Examples of the monomers include: methacrylic acid; crotonic acid; isocrotonic acid; a compound obtained by reaction between a compound having an addition-polymerizable double bond and a hydroxyl group in a molecule thereof (for example, 2-hydroxethyl methacrylate) and succinic anhydride; a compound obtained by reaction between a compound having an addition-polymerizable double bond and a hydroxyl group in a molecule thereof and phthalic anhydride; a compound obtained by reaction between a compound having an addition-polymerizable double bond and a hydroxyl group in a molecule thereof and tetrahydroxyphthalic anhydride; a compound obtained by reaction between a compound having an addition-polymerizable double bond and a hydroxyl group in a molecule thereof and trimellitic anhydride; a compound obtained by reaction between a compound having an addition-polymerizable double bond and a hydroxyl group in a molecule thereof and pyromellitic anhydride; acrylic acid; acrylic acid dimer; acrylic acid oligomer; maleic acid; itaconic acid; fumalic acid; 4-vinylbenzoic acid; vinylphenol; and 4-hydroxyphenylmethacrylamide.

The content of the functional group capable of forming an interaction with titanium black, such as a monomer having an acidic group in the specific rein, is preferably in a range of from 0.05% by mass to 90% by mass, more preferably in a range of from 1.0% by mass to 80% by mass, and still more preferably in a range of from 10% by mass to 70% by mass, with respect to the specific rein, from the viewpoints of interaction with titanium black, dispersion stability, and permeability with respect to a developing solution.

Further, in order to improve various properties such as image strength, the specific resin to be contained in the titanium black dispersion composition according to the present invention may contain a structure unit having the graft unit and the functional group capable of forming an interaction with titanium black, and in addition thereto, other structure units having various functions as a copolymerizing component, such as a structure unit having, for example, a functional group having an affinity with a dispersing medium used in the dispersion, as long as they do not impair the effect of the present invention.

Examples of the copolymerizing component that is copolymerizable with the specific resin include radical polymerizable compounds selected from acrylic acid esters, methacrylic acid esters, styrenes, acrylonitriles, methacrylonitriles, or the like.

These copolymer components may be used, either singly or in combination. The content of these copolymer components favorably used in the specific resin is preferably in a range of from 0% by mole to 90% by mole, and especially preferably in a range of from 0% by mole to 60% by mole. In the case where the content is in the above-described range, a satisfactory pattern formation may be realized.

Examples of a solvent for use in synthesizing the specific resin include ethylene dichloride, cyclohexanone, methylethyl ketone, acetone, methanol, ethanol, propanol, butanol, ethyleneglycol monomethylether, ethyleneglycol monoethylether, 2-methoxyethylacetate, 1-methoxy-2-propanol, 1-methoxy-2-propylacetate, N,N-dimethyl formamide, N,N-dimethyl acetamide, dimethyl sulfoxide, toluene, ethyl acetate, methyl lactate, and ethyl lactate. These solvents may be used, either singly or in mixture of two or more kinds thereof.

Specific examples of the specific resin include the following Exemplary Compounds 1 to 55. In the following structure, the numbers represent the ratio of each constitutional unit (main chain part) in terms of mass%.

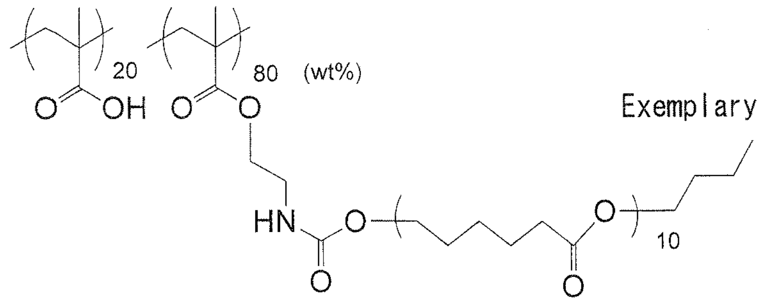

Exemplary Compound 1

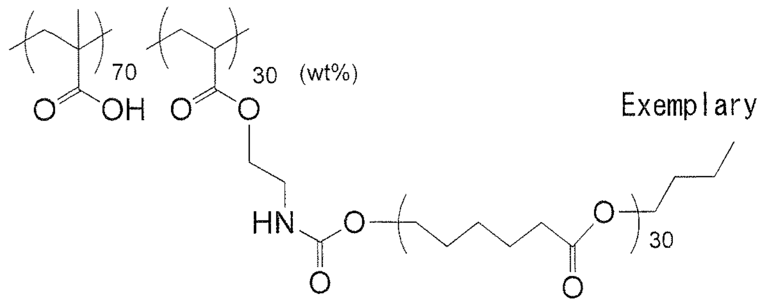

Exemplary Compound 2

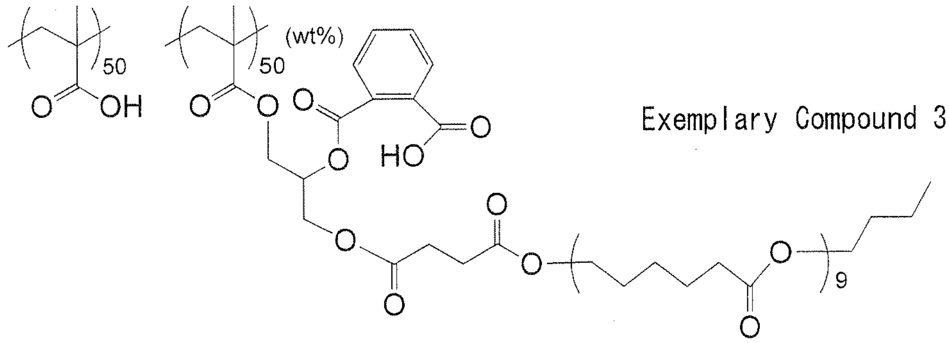

Exemplary Compound 3

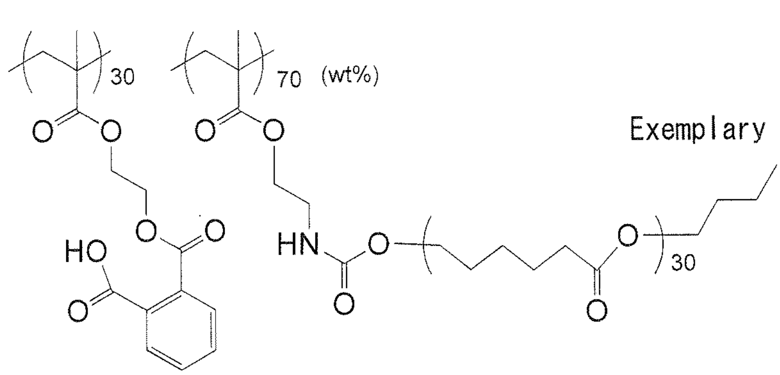

Exemplary Compound 4

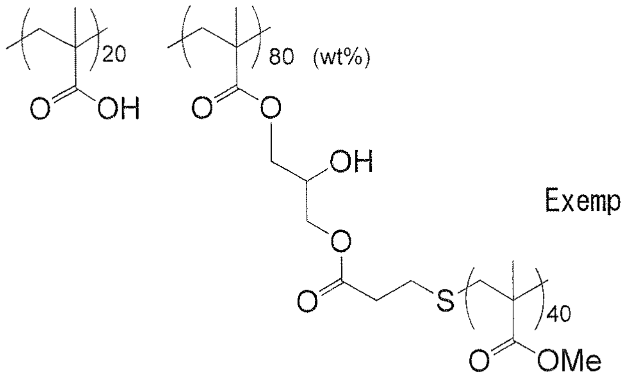

Exemplary Compound 5

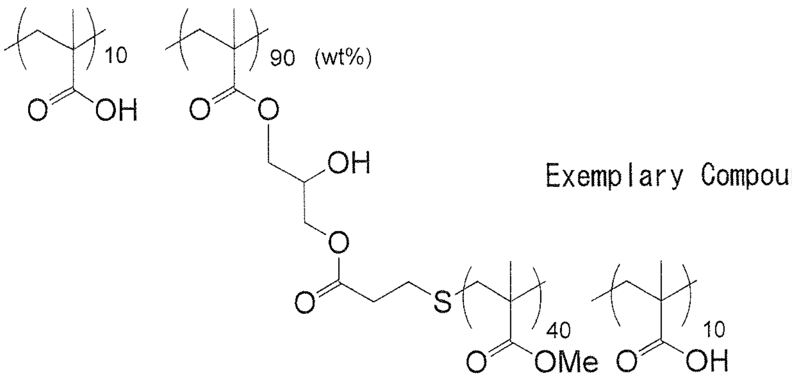

Exemplary Compound 6

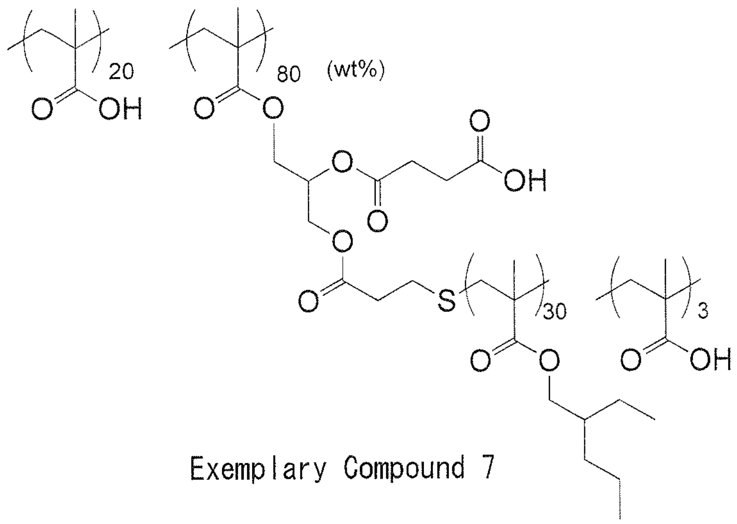

Exemplary Compound 7

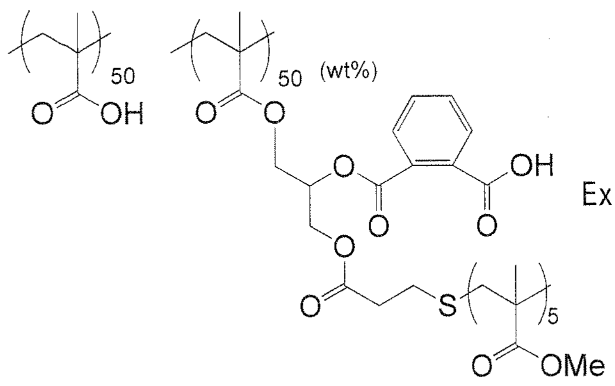

Exemplary Compound 8

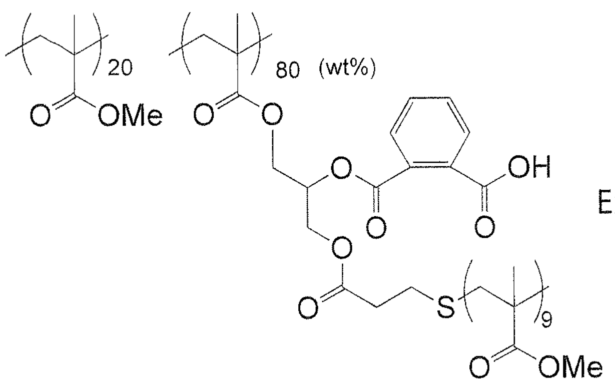

Exemplary Compound 9

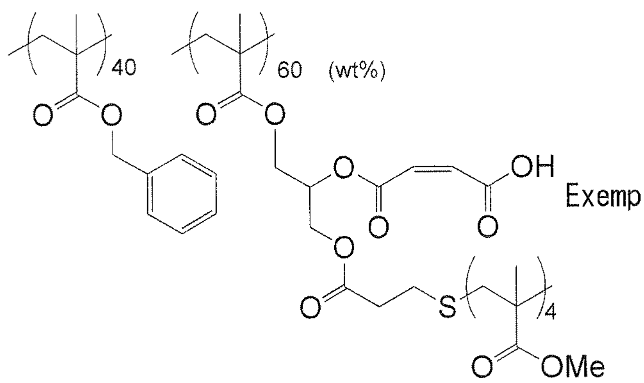

Exemplary Compound 10

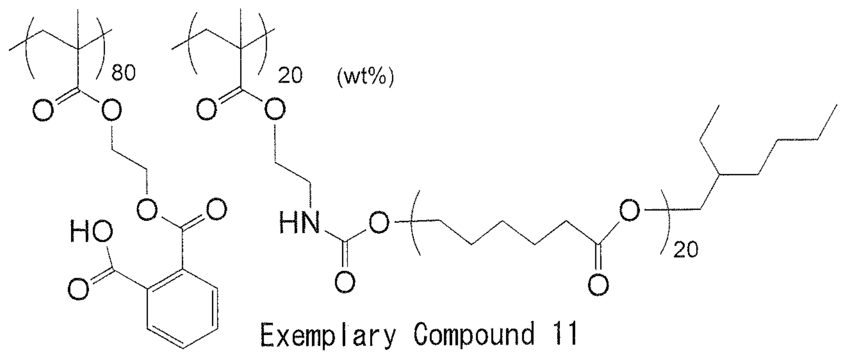

Exemplary Compound 11

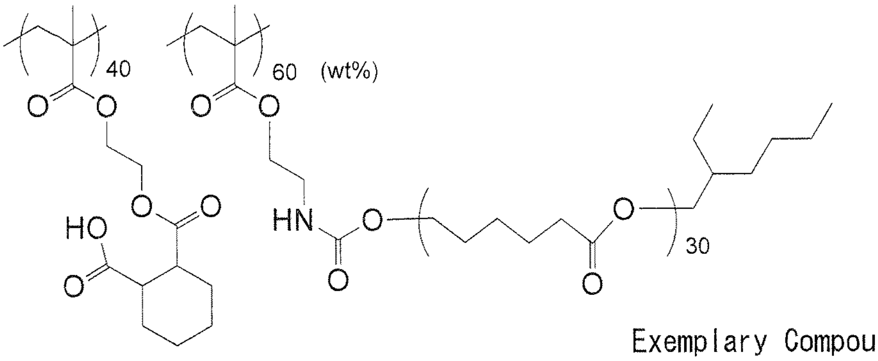

Exemplary Compound 12

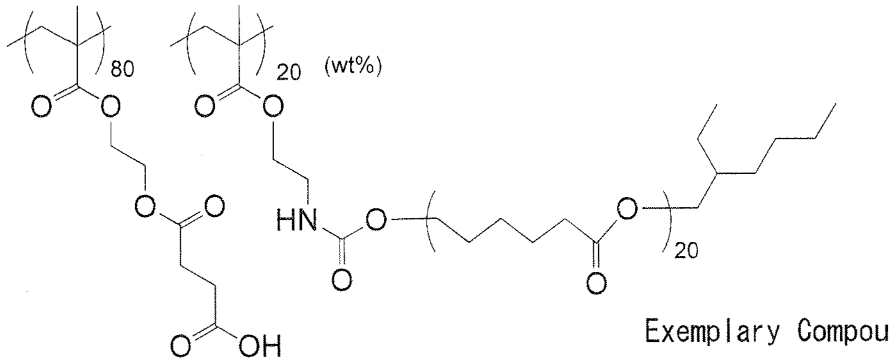

Exemplary Compound 13

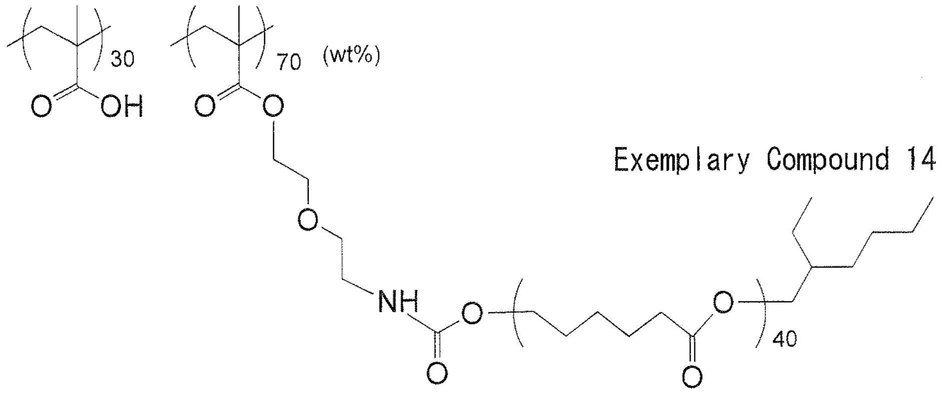

Exemplary Compound 14

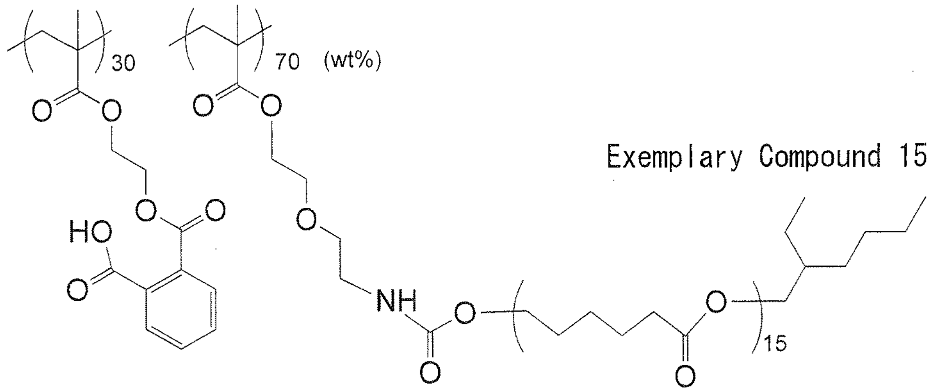

Exemplary Compound 15

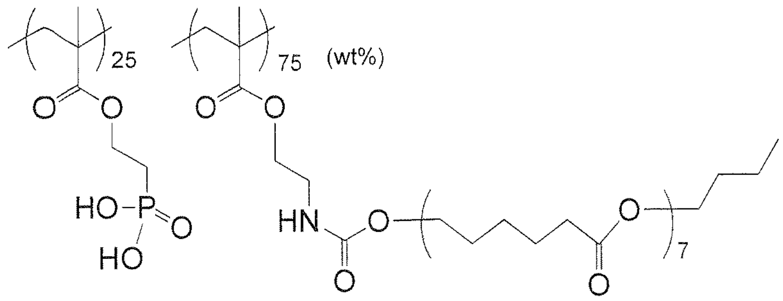

Exemplary Compound 16

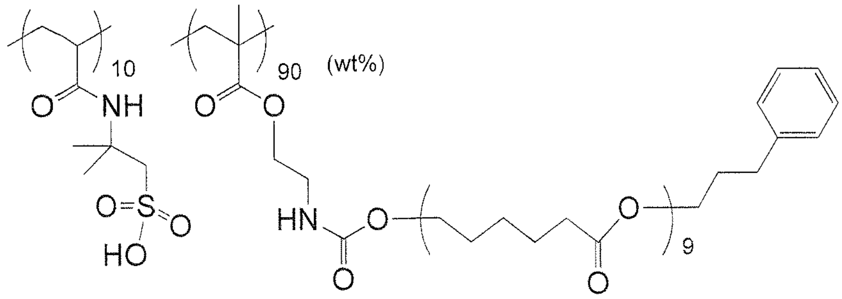

Exemplary Compound 17

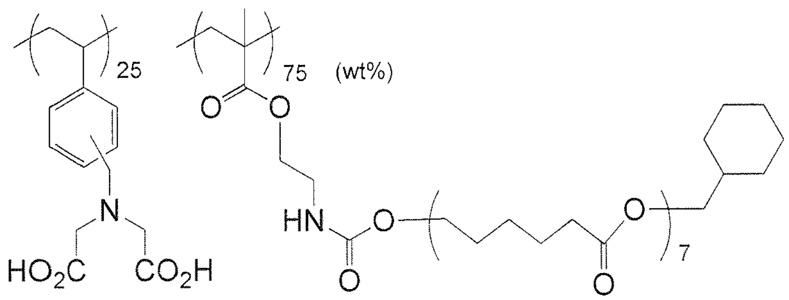

Exemplary Compound 18

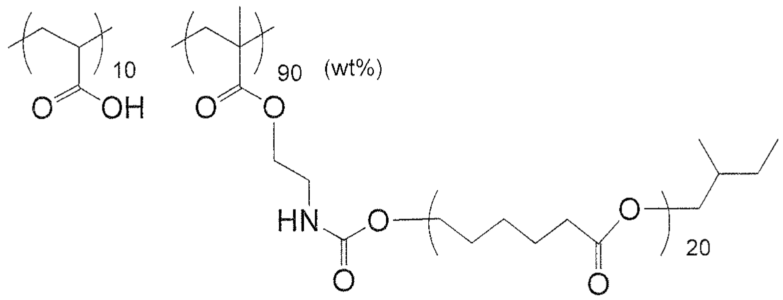

Exemplary Compound 19

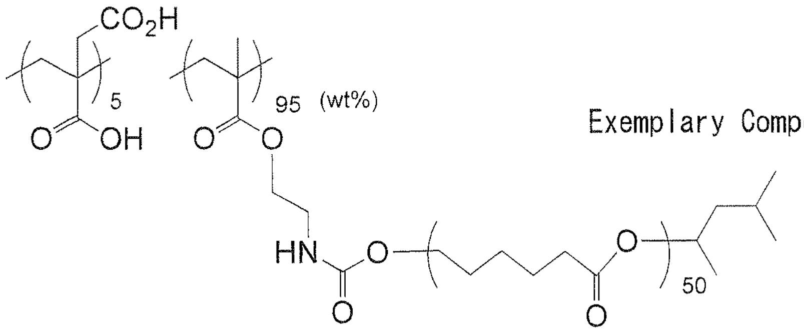

Exemplary Compound 20

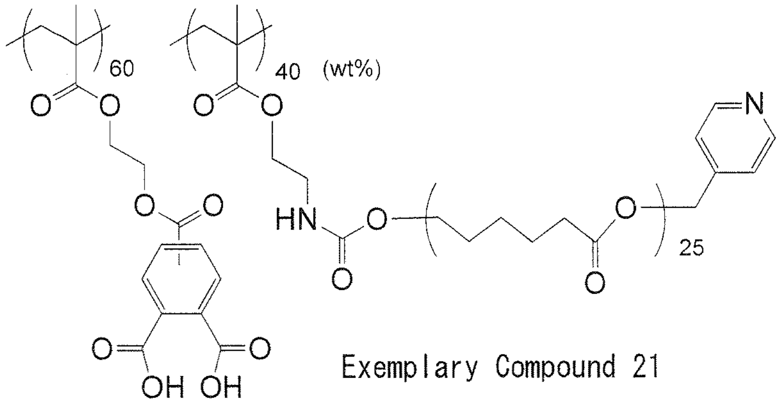

Exemplary Compound 21

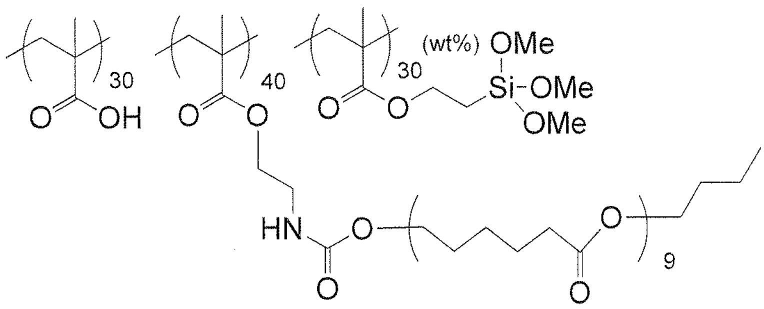

Exemplary Compound 22

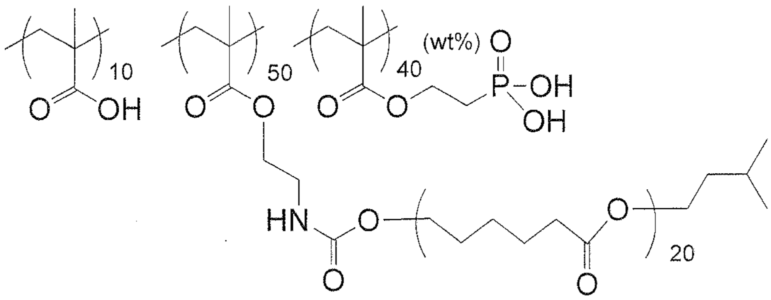

Exemplary Compound 23

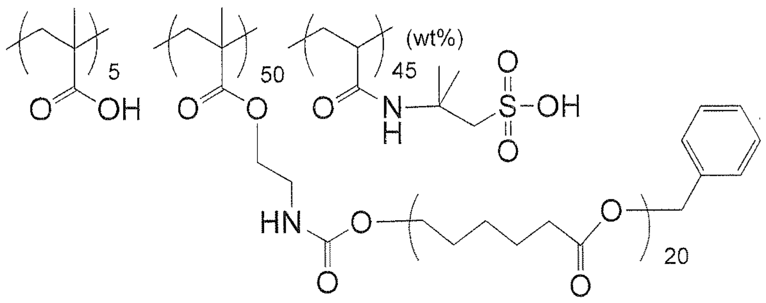

Exemplary Compound 24

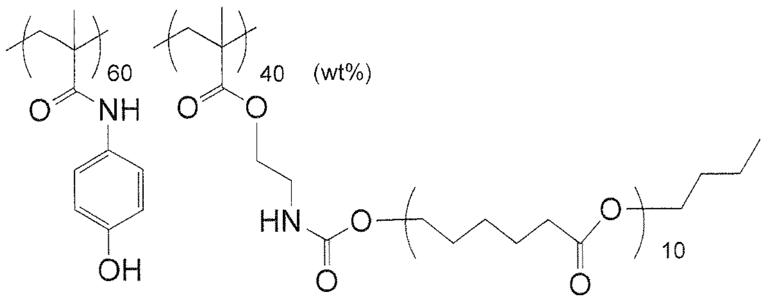

Exemplary Compound 25

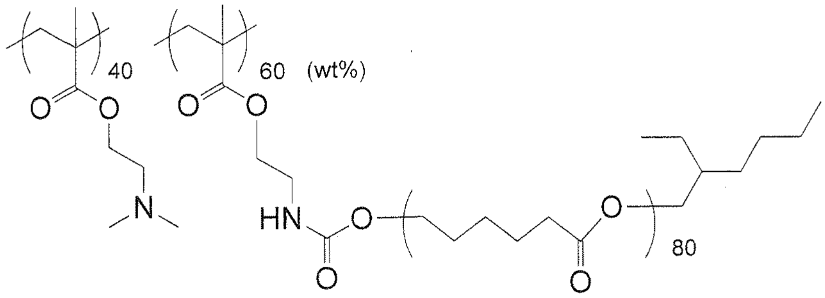

Exemplary Compound 26

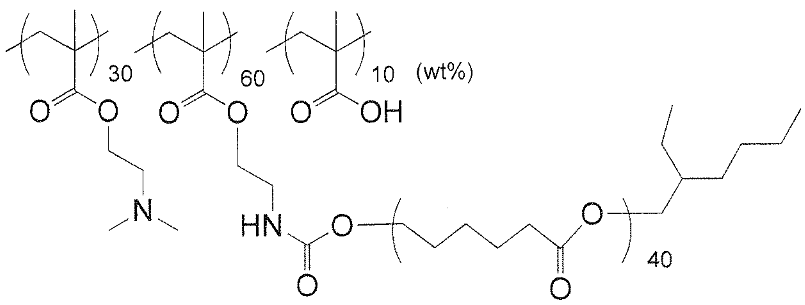

Exemplary Compound 27

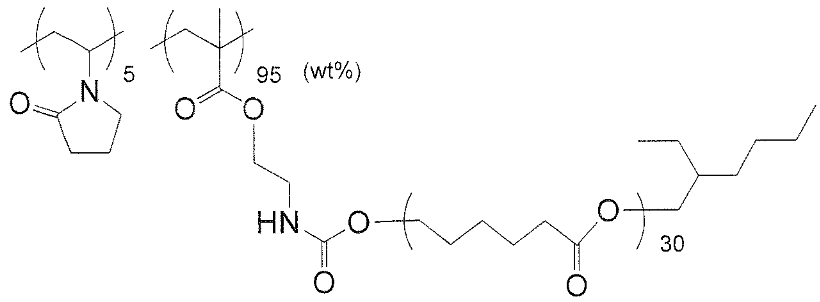

Exemplary Compound 28

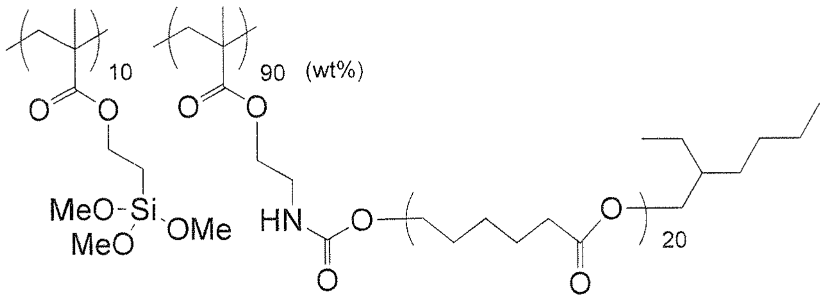

Exemplary Compound 29

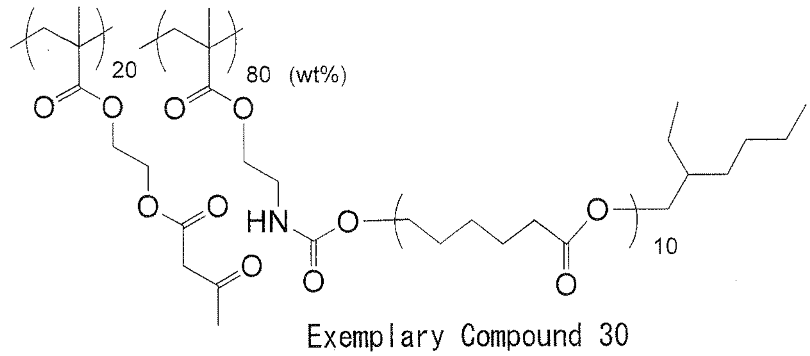

Exemplary Compound 30

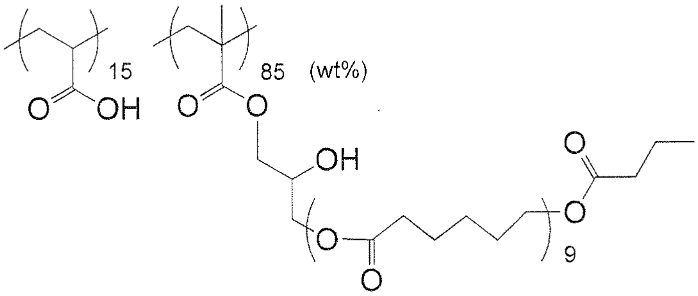

Exemplary Compound 31

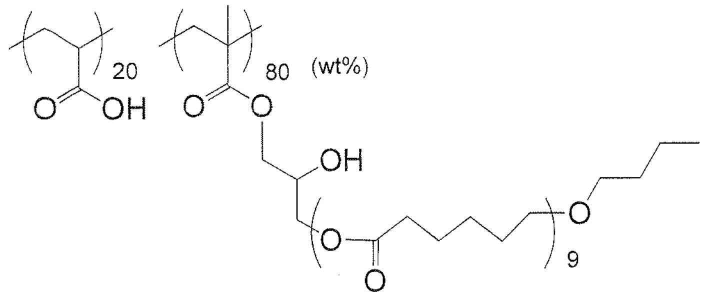

Exemplary Compound 32

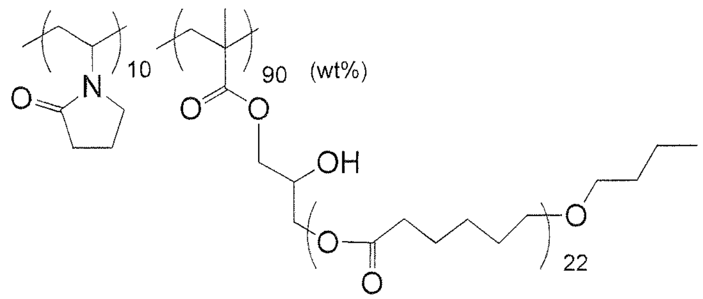

Exemplary Compound 33

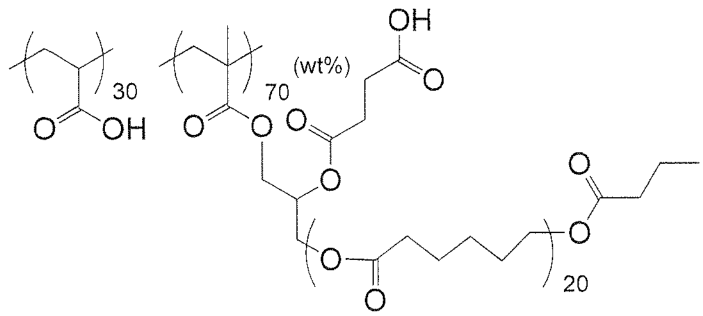

Exemplary Compound 34

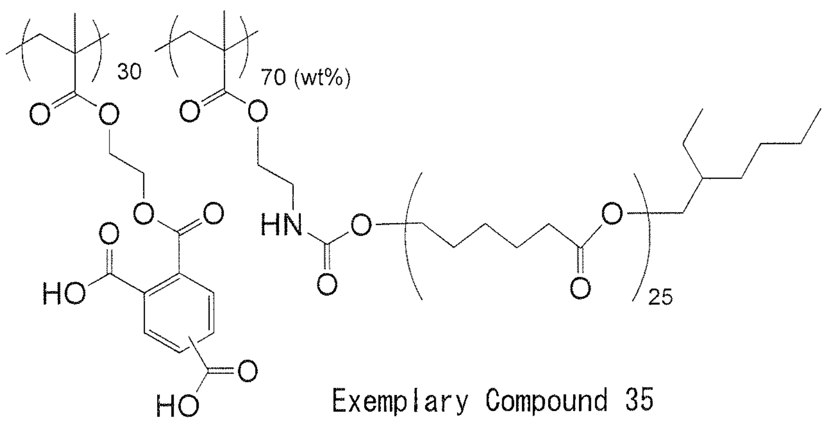

Exemplary Compound 35

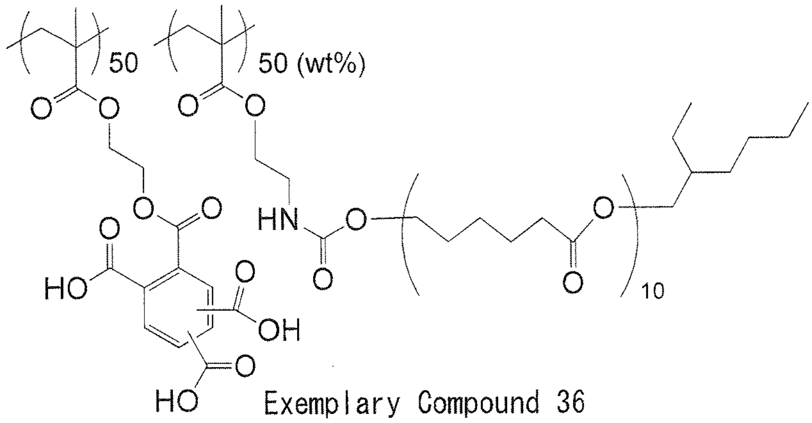

Exemplary Compound 36

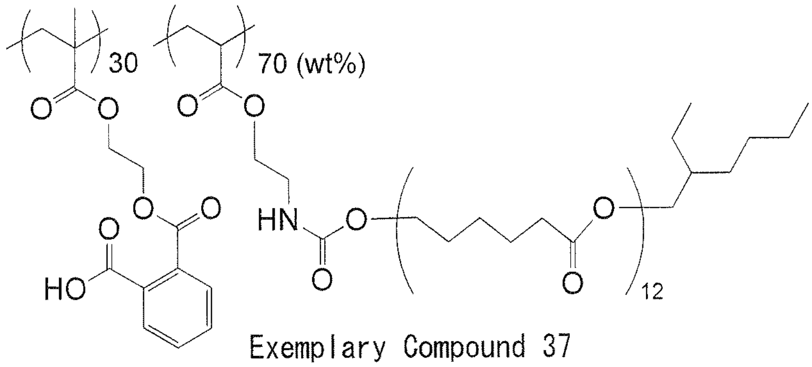

Exemplary Compound 37

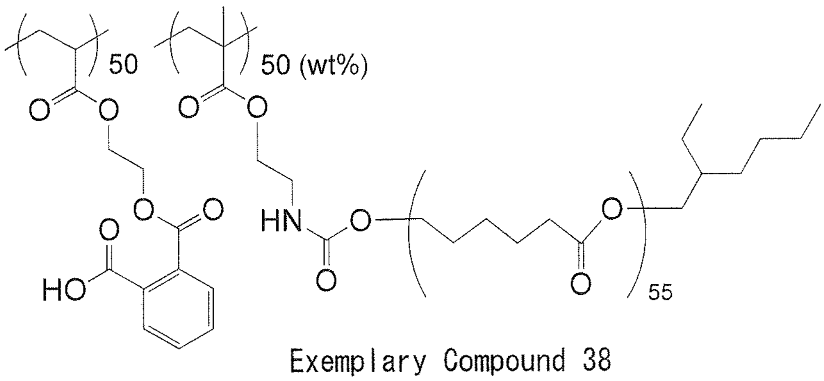

Exemplary Compound 38

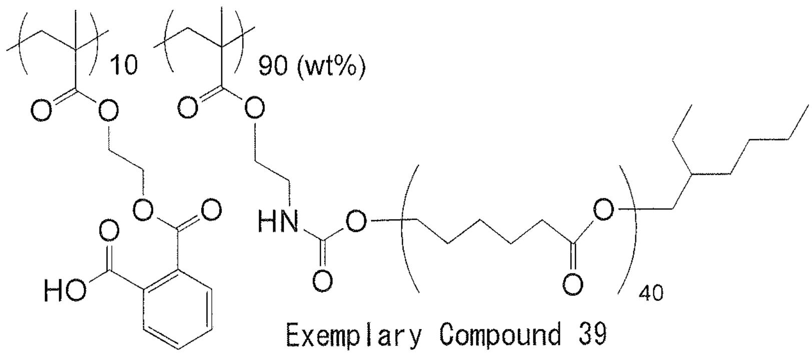

Exemplary Compound 39

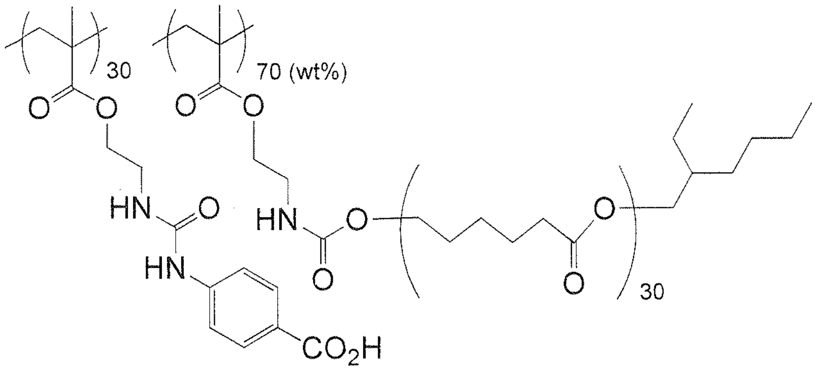

Exemplary Compound 40

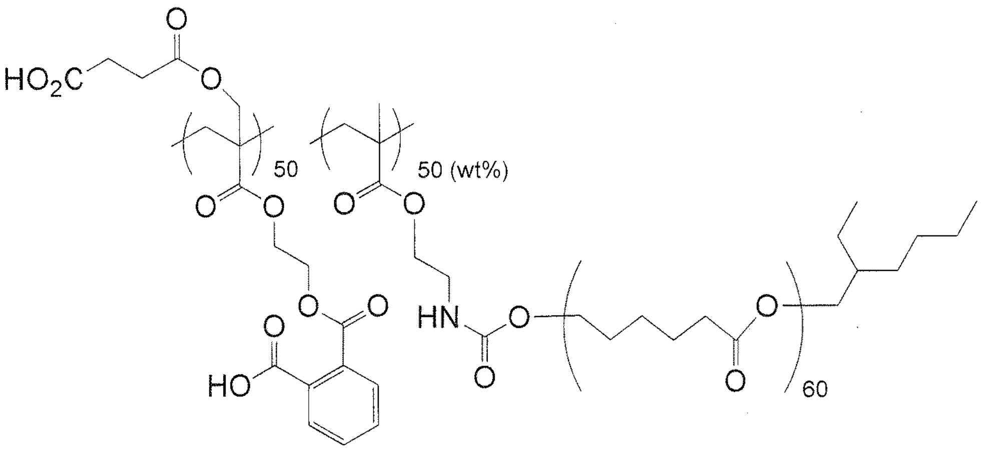

Exemplary Compound 41

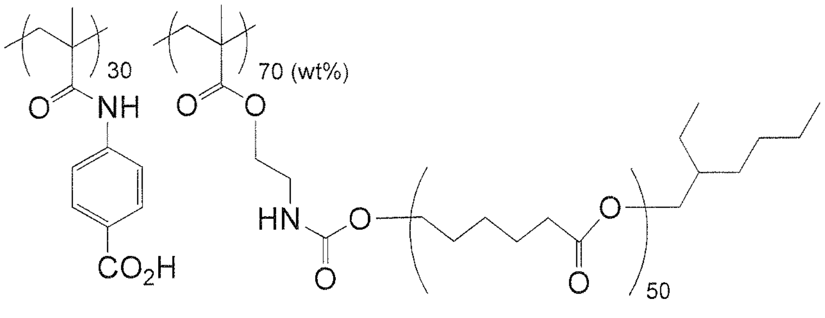

Exemplary Compound 42

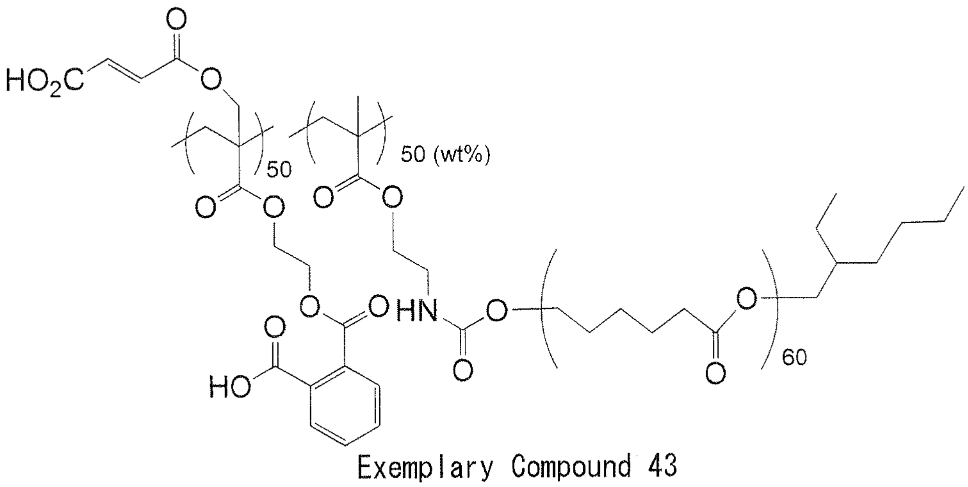

Exemplary Compound 43

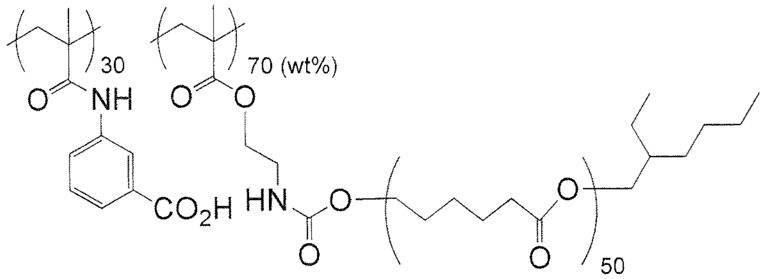

Exemplary Compound 44

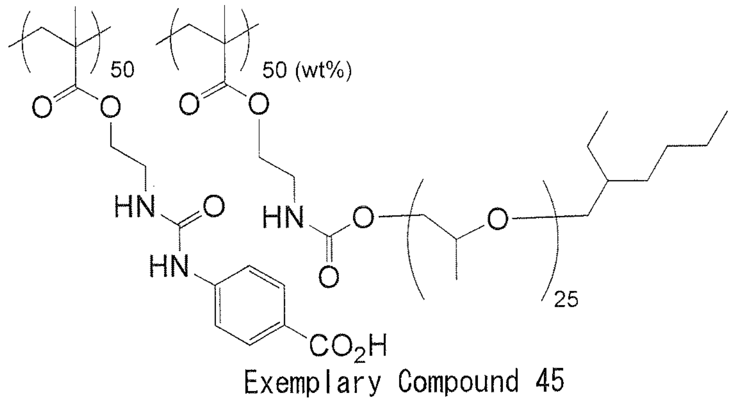

Exemplary Compound 45

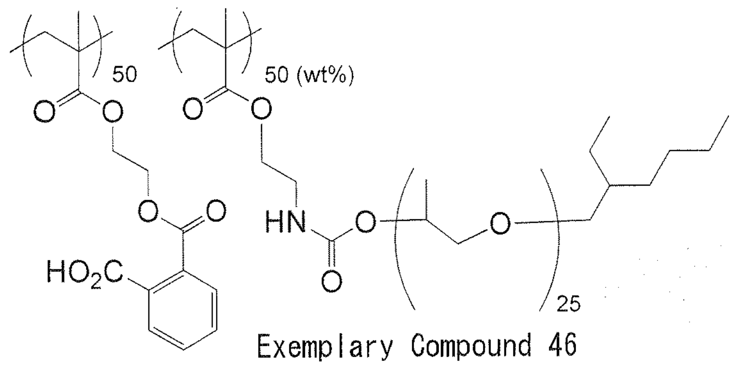

Exemplary Compound 46

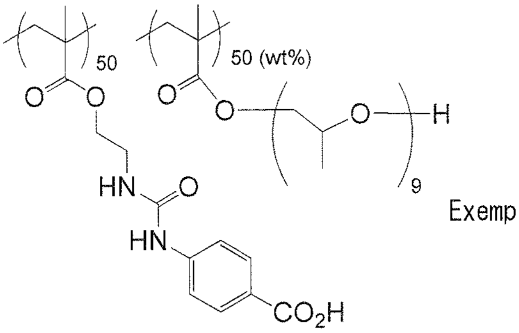

Exemplary Compound 47

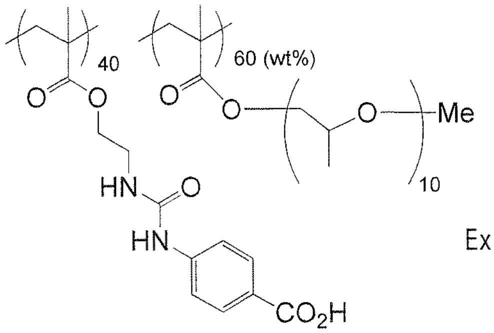

Exemplary Compound 48

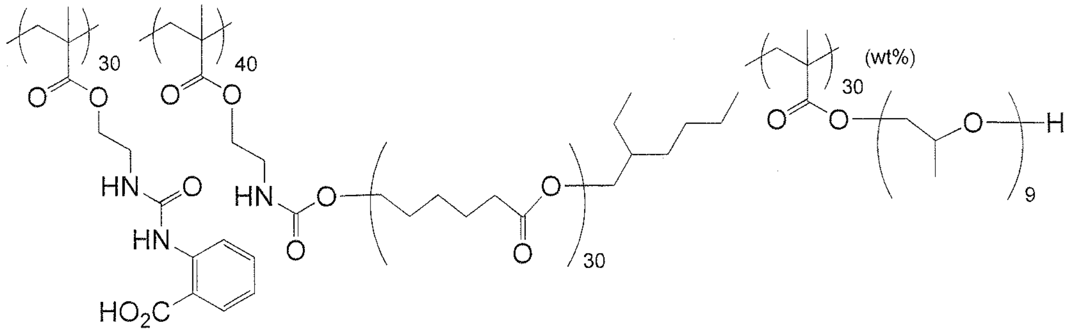

Exemplary Compound 49

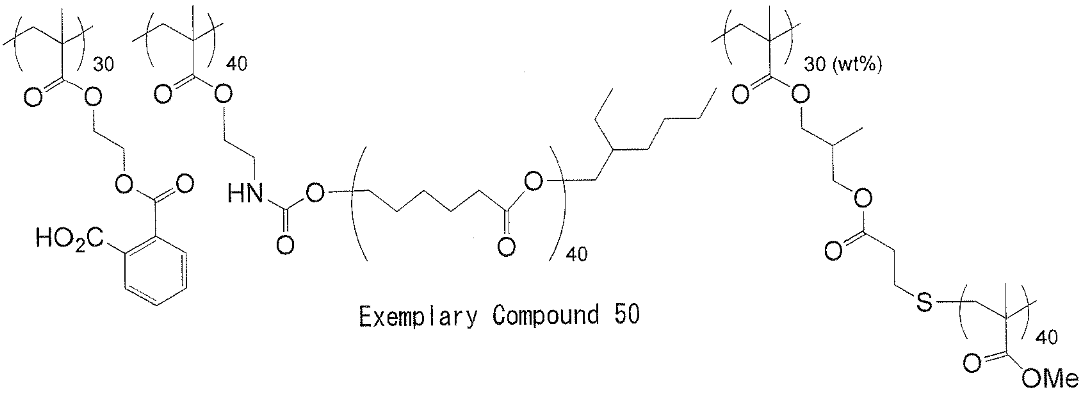

Exemplary Compound 50

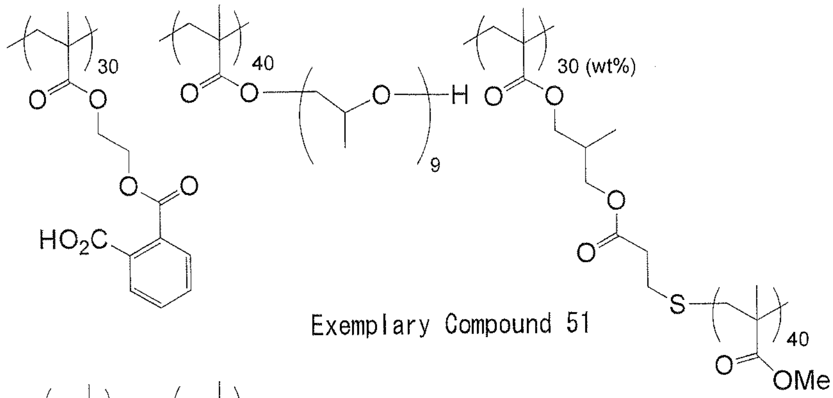

Exemplary Compound 51

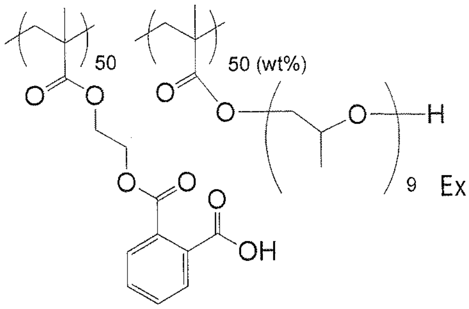

Exemplary Compound 52

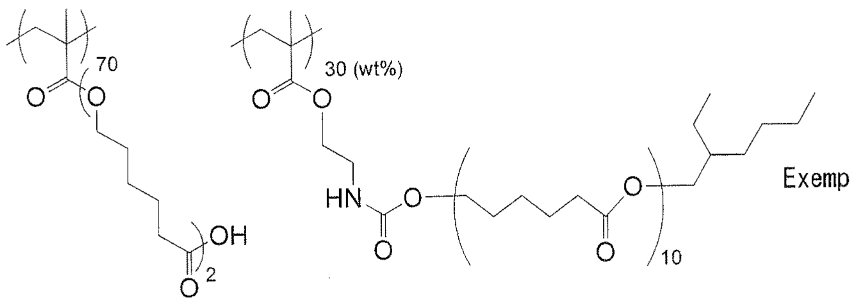

Exemplary Compound 53

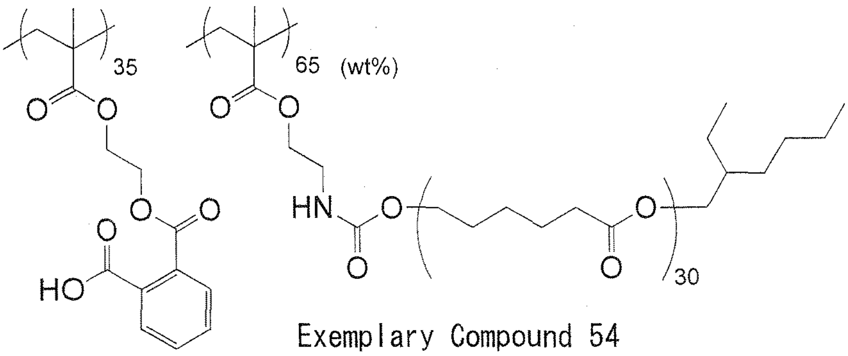

Exemplary Compound 54

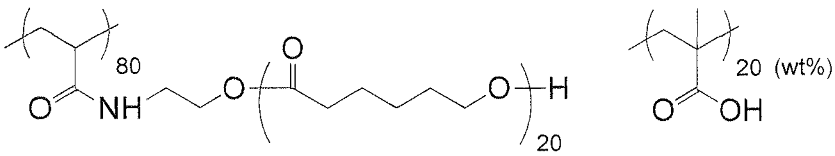

Exemplary Compound 55

The content of the dispersant in the (A) pigment dispersion used in the present invention is preferably in a range of from 1% by mass to 90% by mass, and more preferably in a range of from 3% by mass to 70% by mass, with respect to the total solid content mass of the dispersed material (including a dispersed material including titanium black

particles and other coloring agents).

Further, the content of the dispersant in the radiation-sensitive composition is preferably in a range of from 1% by mass to 90% by mass, and more preferably in a range of from 3% by mass to 70% by mass, with respect to the total solid content mass of the dispersed material (including a dispersed material including titanium black particles and other coloring agents).

(a-3) Organic solvent

The (A) pigment dispersion used in the present invention contains (a-3) an organic solvent.

Examples of the organic solvent include acetone, methylethyl ketone, cyclohexane, ethyl acetate, ethylene dichloride, tetrahydrofuran, toluene, ethyleneglycol monomethylether, ethyleneglycol monoethylether, ethyleneglycol dimethylether, propyleneglycol monomethylether, propyleneglycol monoethylether, acetylacetone, cyclohexanone, diacetone alcohol, ethyleneglycol monomethylether acetate, ethyleneglycol ethylether acetate, ethyleneglycol monoisopropylether, ethyleneglycol monobutylether acetate, 3-methoxypropanol, methoxymethoxyethanol, diethyleneglycol monomethylether, diethyleneglycol monoethylether, diethyleneglycol dimethylether, diethyleneglycol diethylether, propyleneglycol monomethylether acetate, propyleneglycol monoethylether acetate, 3-methoxypropyl acetate, N,N-dimethylformamide, dimethylsulfoxide, γ-butyrolactone, ethylacetate, butyl acetate, methyl lactate, and ethyl lactate. However, the organic solvent is not limited thereto.

The organic solvent may be used, either singly or in combination of two or more kinds thereof.

In the case where the organic solvent is used in combination of two or more kinds thereof, an especially preferable combination of solvents is a mixed solvent composed of two or more solvents selected from methyl 3-ethoxypropionate, ethyl 3-ethoxypropionate, ethyl cellosolve acetate, ethyl lactate, diethyleneglycol dimethylether, butyl acetate, methyl 3-methoxypropionate, 2-heptanone, cyclohexanone, ethylcarbitol acetate, butylcarbitol acetate, propyleneglycol methylether, and propyleneglycol methylether acetate, as described above.

The amount of the organic solvent contained in the titanium black dispersion is preferably in a range of from 10% by mass to 80% by mass, more preferably in a range of from 20% by mass to 70% by mass, and still more preferably in a range of from 30% by mass to 65% by mass, with respect to the total amount of the titanium black dispersion.

Further, the amount of the solvent contained in the radiation-sensitive composition is preferably in a range of from 10% by mass to 90% by mass, more preferably in a range of from 20% by mass to 80% by mass, and still more preferably in a range of from 25% by mass to 75% by mass, with respect to the total amount of the radiation-sensitive composition.

(B) Polymerizable compound

The radiation-sensitive composition used in the light-shielding film of the invention includes a polymerizable compound.

As the polymerizable compound, a compound which has at least one addition-polymerizable ethylenically unsaturated group, and has a boiling point of 100°C or higher at normal pressure, is preferable.

Examples of the compound which has at least one addition-polymerizable ethylenically unsaturated group and has a boiling point of 100°C or higher at normal pressure include: monofunctional acrylates or methacrylates such as polyethylene glycol mono(meth)acrylate, polypropylene glycol mono(meth)acrylate, or phenoxyethyl(meth)acrylate; and polyfunctional acrylates or methacrylates such as: polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol hexa(meth)acrylate, hexanediol (meth)acrylate, trimethylolpropane tri(acryloyloxypropyl)ether, tri(acryloyloxyethyl)isocyanurate; compounds obtained by adding ethylene oxide or propylene oxide to a polyfunctional alcohol such as glycerin or trimethylolethane, and then (meth)acrylating the same; poly(meth)acrylated pentaerythritol or poly(meth)acrylated dipentaerythritol; urethane acrylates described in Japanese Examined Patent Application Publication (JP-B) Nos. 48-41708 and 50-6034 and JP-A No. 51-37193; polyester acrylates described in JP-A No. 48-64183 and JP-B Nos. 49-43191 and 52-30490; and epoxy acrylates, which is a compound obtained by reaction between an epoxy resin and (meth)acrylic acid.

Further, compounds that are described as photocurable monomers and oligomers in Nihon Secchaku Kyoukaishi (Journal of the Adhesion Society of Japan), Vol. 20, No. 7, pp. 300 to 308, can also be used.

Furthermore, the compounds obtained by adding ethylene oxide or propylene oxide to a polyfunctional alcohol and then (meth)acrylating the same, which are described in JP-A No. 10-62986 as Formulae (1) and (2) together with specific examples thereof, can also be used.

Among those, dipentaerythritol penta(meth)acrylate, dipentaerythritol hexa(meth)acrylate, and those having a structure in which the acryloyl group is connected to the dipentaerythritol via an ethylene glycol or propylene glycol residue are preferable. The oligomer types thereof can also be used.

In addition, urethane acrylates described in JP-B No. 48-41708, JP-A No. 51-37193, and JP-B Nos. 2-32293 and 2-16765, and urethane compounds having an ethylene oxide-based skeleton described in JP-B Nos. 58-49860, 56-17654, 62-39417, and 62-39418 are also preferable. Furthermore, by using addition-polymerization compounds having an amino structure or a sulfide structure in the molecule, as described in JP-A Nos. 63-277653, 63-260909, and 1-105238, a photopolymerizable composition that is excellent in reaction speed with respect to light can be obtained. Examples of the commercially available product include: urethane oligomers UAS-10 and UAB-140 (trade names, manufactured by NIPPON PAPER CHEMICALS CO., LTD.); UA-7200 (trade name, manufactured by Shin-Nakamura Chemical Co., Ltd.; DPHA-40H (trade name, manufactured by Nippon Kayaku Co., Ltd.); and UA-306H, UA-306T, UA-3061, AH-600, T-600, andAI-600 (all trade names, manufactured by Kyoeisha Chemical Co., Ltd.).

In addition, ethylenically unsaturated compounds having an acid group are also preferred. Examples of commercial products include TO-756 (carboxy group-containing trifunctional acrylate) and TO-1382 (carboxy group-containing pentafunctional acrylate) (trade names, manufactured by Toagosei Co., Ltd.).

The polymerizable compound used in the present invention is more preferably a tetra or more functional compound.

The polymerizable compounds may be used either singly or in combination of two or more kinds thereof. In the case where two or more kinds of photopolymerizable compounds are used, an embodiment of the combination may be determined appropriately in accordance with physical properties and the like that are required for the photosensitive composition. As a preferable embodiment of the combination of the photopolymerizable compounds, one example is a combination of two or more kinds of polymerizable compounds selected from the above-described polyfunctional acrylate compounds, such as a combination of dipentaerythritol hexaacrylate and pentaerythritol triacrylate.

The content of the polymerizable compound in the photosensitive composition is preferably in a range of from 3 parts to 55 parts, and more preferably in a range of from 10 parts to 50 parts, based on 100 parts of the total solid contents, in terms of mass.

(C) Polymerization Initiator

The photosensitive composition used in the invention includes a polymerization initiator.

The photopolymerization initiator is a compound which decomposes with light or heat to initiate and promote polymerization of the polymerizable compound as described above, and preferably has an absorption to light in a wavelength region of from 300 nm to 500 nm.

Specific examples of the photopolymerization initiator include an organic halide compound, an oxydiazole compound, a carbonyl compound, a ketal compound, a benzoin compound, an organic peroxide compound, an azo compound, a coumarin compound, an azide compound, a metallocene compound, an organic boric acid compound, a disulfonic acid compound, an oxime ester compound, an onium salt compound, and an acyl phosphine (oxide) compound.

More specific examples of the photopolymerization initiator include the photopolymerization initiators described in Paragraphs [0081] to [0100], and [0101] to [0139] of JP-A No. 2006-78749.

Among these photopolymerization initiators, an oxime ester compound is especially preferable.

The content of the polymerization initiator in the radiation-sensitive composition relating to the invention is preferably in a range of from 0.1% by mass to 30% by mass, more preferably in a range of from 1% by mass to 25% by mass, and still more preferably in a range of from 2% by mass to 20% by mass, in the total solid content of the photosensitive composition.

(F) Other Additives

In the radiation-sensitive composition used in the invention, various additives may be optionally contained according to the purposes, in addition to the (A) pigment dispersion, the (B) polymerizable compound, and the (C) polymerization initiator.

(F-1) Binder Polymer

A binder polymer may be used in the radiation-sensitive composition for the purpose of improving film characteristics and the like.

A linear organic polymer is preferably used as a binder polymer, and any known linear organic polymers may be used. In order to carry out development with water or weak alkali water, a linear organic polymer that is soluble or swellable in water or weak alkali water is preferably selected. The linear organic polymer may be selected and used not only as as a film-forming agent but also as an organic solvent developer for water or weak aliali water development.

For example, use of a water-soluble organic polymer makes it possible to carry out development with water. Examples of the linear organic polymers include: a radical polymer having a carboxylic acid group in a side chain; linear

organic polymers described in, for example, JP-A No. 59-44615, JP-B Nos. 54-34327, 58-12577, 54-25957, JP-A Nos. 54-92723, 59-53836 and 59-71048, i.e., resins obtained from polymerization or copolymerization of a monomer having a carboxylic group, resins obtained from processes of polymerizing or copolymerizing a monomer having an acid anhydride, and subjecting the resultant acid anhydride unit to hydrolysis, half-esterification or half-amidation, and an epoxy acrylate obtained by modifying an epoxy resin with an unsaturated monocarboxylic acid or an acid anhydride. Examples of the monomer having a carboxylic group include acrylic acid, methacrylic acid, itaconic acid, crotonic acid, maleic acid, fumaric acid, and 4-carboxylstyrene. Examples of the monomer having an acid anhydride include maleic acid anhydride.

Further examples include acidic cellulose derivatives having a carboxylic acid group in a side chain thereof. In addition, a cyclic acid anhydride adduct of the polymer having a hydroxyl group, and the like are also useful.

Furthermore, urethane-based binder polymers having an acid group, as described in JP-B No. 7-120040, JP-B No. 7-120041, JP-B No. 7-120042, JP-B No. 8-12424, JP-A No. 63-287944, JP-A No. 63-287947, JP-A No. 1-271741, and Japanese Patent Application No. 10-116232, exhibit excellent strength and are advantageous in respect of low-exposure suitability.

Further, acetal-modified polyvinyl alcohol-based binder polymers having an acid group, as described in European Patent (EP) No. 993966, EP No. 1204000, JP-A No. 2001-318463, and the like are preferable because of a favorable balance between the film strength and the developability. Other examples of the useful water-soluble linear organic polymers include polyvinyl pyrrolidone, polyethylene oxide, and the like. In order to increase the strength of the cured film, alcohol-soluble nylon, polyethers of 2,2-bis-(4-hydroxyphenyl)-propane and epichlorohydrin, and the like are also useful.

Among the linear organic polymers, a copolymer of benzyl(meth)acrylate, (meth)acrylic acid and optionally other addition-polymerizable vinyl monomers, and a copolymer of allyl(meth)acrylate, (meth)acrylic acid and optionally other addition-polymerizable vinyl monomers are suitable becauce of favorable balance among the film strength, sensitivity, and developability.

The weight average molecular weight of the binder polymer that is usable in the radiation-sensitive composition is preferably in a range of 1,000 to 300,000, more preferably in a range of from 1,500 to 250,000, still more preferably in a range of from 2,000 to 200,000, and still more preferably in a range of from 2,500 to 100,000. The number average molecular weight thereof is preferably 1,000 or more, and more preferably in a range of from 1, 500 to 250,000. Further, the polydispersivity of the binder polymer (weight average molecular weight/ number average molecular weight) is preferably 1 or more, and more preferably in a range of from 1.1 to 10.

The binder polymer may be any one of a random polymer, a block polymer or a graft polymer.

The binder polymer that may be used in the invention can be synthesized in accordance with any known methods. Examples of the solvent used in the synthesis include tetrahydrofuran, ethylene dichloride, and cyclohexanone. These solvents may be used either singly or in combination of two or more kinds thereof.

Further, examples of the radical polymerization initiator that may be used in the synthesis of the binder polymer include known compounds such as an azo-based initiator or a peroxide initiator.

By including an alkali-soluble resin having a double bond in a side chain in a binder polymer, it becomes possible to improve both curability at an exposed area and development property at an unexposed area, in particular.

The alkali-soluble binder polymers (resins) having a double bond in a side chain makes it possible to improve various properties such as removability of a non-image area, because they have an acid group that imparts alkali solubility to the resin, and at least one unsaturated double bond in the structure of the resin. Details of the binder resins having a partial structure as described above are described in JP-A No. 2003-262958, and compounds described therein may be used in the invention.

The weight-average molecular weight of the binder polymer may be measured by GPC, for example.

The content of the binder polymer in the radiation-sensitive composition is preferably in a range of from 0.1 % by mass to 7.0% by mass, based on the total solid content of the composition, and from the viewpoint of suppressing peeling off of a light-shielding film and suppressing generation of development residues at the same time, it is more preferably in a range of from 0.3% by mass to 6.0% by mass, and still more preferably in a range of from 1.0% by mass to 5.0% by mass.

(F-2) Colorants

In the invention, colorants other than inorganic pigments, such as known organic pigments or dyes may be used in combination with the inorganic pigments, in order to obtain a desired light-shielding property.

Examples of the colorant which may be used in combination with inorganic pigments include: the pigments described in Paragraphs [0030] to [0044] of JP-A No. 2008-224982; and C. I. Pigment Green 58 and C. I. Pigment Blue 79 in which Cl substituents are changed to OH. Among those, examples of the pigments that can be favorably used are as follows. However, the present invention is not limited thereto.

C.I. Pigment Yellow 11, 24, 108, 109, 110, 138, 139, 150, 151, 154, 167, 180, 185;

C.I. Pigment Orange 36, 38, 62, 64;
C.I. Pigment Red 122, 150, 171, 175, 177, 209, 224, 242, 254, 255;
C.I. Pigment Violet 19, 23, 29, 32;
C.I. Pigment Blue 15:1, 15:3, 15:6, 16, 22, 60, 66;
C.I. Pigment Green 7, 36, 37, 58; and
C.I. Pigment Black 1.

The dyes which may be used as the colorant are not particularly limited, and may be selected from any known dyes appropriately. Examples of the dyes include dyes disclosed in JP-A No. 64-90403, JP-A No. 64-91102, JP-A No. 1-94301, JP-A No. 6-11614, Japanese Patent No. 2592207, US Patent No. 4,808,501, U.S. Patent No. 5,667,920, U.S. Patent No. 5,059,500, JP-A No. 5-333207, JP-A No. 6-35183, JP-A No. 6-51115, JP-A No. 6-194828, JP-A No. 8-211599, JP-A No. 4-249549, JP-A No. 10-123316, JP-A No. 11-302283, JP-A No. 7-286107, JP-A No. 2001-4823, JP-A No. 8-15522, JP-A No. 8-29771, JP-A No. 8-146215, JP-A No. 11-343437, JP-A No. 8-62416, JP-A No. 2002-14220, JP-A No. 2002-14221, JP-A No. 2002-14222, JP-A No. 2002-14223, JP-A No. 8-302224, JP-A No. 8-73758, JP-A No. 8-179120, and JP-A No. 8-151531.

From the viewpoint of the chemical structute of the dye, examples include pyrazole azo dyes, anilino azo dyes, triphenylmethane dyes, anthraquinone dyes, anthrapyridone dyes, benzylidene dyes, oxonol dyes, pyrazolotriazole azo dyes, pyridone azo dyes, cyanine dyes, phenothiazine dyes, pyrrolopyrazole azomethine dyes, xanthene dyes, phthalocyanine dyes, benzopyran dyes, indigo dyes and pyrromethene dyes.

The colorant used in the radiation-sensitive composition, which is used in combination with titanium black particles as an essential component, is preferably at least one orange pigment selected from a group consisting of an orange pigment, a red pigment, and a violet pigment from the viewpoints of achieving a favorable curability and a favorable light-shielding property at the same time, and most preferably a red pigment.

The orange pigment, the red pigment, or the violet pigment used in combination with titanium black particles may be selected appropriately in accordance with a target light-shielding property, for example, from various pigments belonging to the C.I. Pigment Orange group, the C.I. Pigment Red group and the C.I. Pigment Violet group as described above. From the viewpoint of improving the light-shielding property, C.I. Pigment Violet 29, C.I. Pigment Orange 36, 38, 62, 64, C. I. Pigment Red 177, 254 and 255, and the like are preferable.

(F-3) Sensitizer

The radiation-sensitive composition may contain a sensitizer for the purpose of improving the radical generating efficiency of a polymerization initiator, and extending the wavelength of light to which the radiation-sensitive composition is sensitive.

The sensitizer is preferably a compound that sensitizes a polymerization initiator used in combination with the sensitizer by means of an electron transfer mechanism or an energy transfer mechanism.

Preferable examples of the sensitizer include the compounds described in Paragraphs [0085] to [0098] of JP-A No. 2008-214395.

The content of the sensitizer is preferably in a range of from 0.1 % by mass to 30% by mass, more preferably in a range of from 1% by mass to 20% by mass, and still more preferably in a range of from 2% by mass to 15% by mass, based on the total solid content of the radiation-sensitive composition, from the viewpoints of sensitivity and storage stability.

(F-4) Polymerization Inhibitor

It is preferable that the radiation-sensitive composition contains a small amount of a polymerization inhibitor in order to inhibit undesirable thermal polymerization of a polymerizable compound during production or storage of the composition. Any known thermal polymerization inhibitors may be used as the polymerization inhibitor, and specific examples thereof include hydroquinone, p-methoxyphenyl, di-t-butyl-p-cresol, pyrogallol, t-butylcatechol, benzoquinone, 4,4'-thiobis-(3-methyl-6-t-butylphenol), 2,2'-methylenebis-(4-methyl-6-t-butylphenol), and N-nitrosophenylhydroxylamine cerium (I) salt.

The content of the thermal polymerization inhibitor is preferably in a range of from about 0.01% by mass to about 5% by mass with respect to the total solid content of the radiation-sensitive composition.

The radiation-sensitive composition may optionally contain, for example, a higher fatty acid derivative such as behenic acid or behenic acid amide, such that the higher fatty acid derivative is positioned on a surface of a coating film formed from the radiation-sensitive composition during drying the same, for the purpose of preventing polymerization inhibition caused by oxygen. The content of the higher fatty acid derivative is preferably in a range of from about 0.5% by mass to about 10% by mass with respect to the total mass of the radiation-sensitive composition.

(F-5) Adhesion Promoter

An adhesion promoter may be added to the radiation-sensitive composition in order to improve adhesiveness to a surface of a hard material such as a support. Examples of the adhesion promoter include a silane coupling agent and a titanium coupling agent.

Preferable examples of the silane coupling agent include γ-methacryloxypropyl trimethoxy silane, γ-methacryloxypropyl triethoxy silane, γ-acryloxypropyl trimethoxy silane, γ-acryloxypropyl triethoxy silane, γ-mercaptopropyl trimethoxy silane, γ-aminopropyl triethoxy silane and phenyl trimethoxy silane. More preferable examples include γ-methacryloxypropyl trimethoxy silane.

The content of the adhesion promoter is preferably in a range of from 0.5% by mass to 30% by mass, and more preferably in a range of from 0.7% by mass to 20% by mass, with respect to the total solid content of the radiation-sensitive composition.

(F-6) Surfactant

The radiation-sensitive composition may further include various surfactants, from the viewpoint of further improving the coatability. As the surfactant, various surfactants such as a fluorine-based surfactant, a nonion-based surfactant, a cation-based surfactant, an anion-based surfactant, or a silicon-based surfactant, may be used.

In particular, when the radiation-sensitive composition used in the invention contains a fluorine-based surfactant, liquid properties (in particular, fluidity) of the composition when it is prepared as a coating liquid are improved, and uniformity in the coating thickness and a liquid saving property can be further improved.

That is, when a radiation-sensitive composition including a fluorine-based surfactant is used as a coating liquid to form a film, wettability on the coating surface is improved due to a decrease in the surface tension between the surface to be coated and the coating liquid, whereby the coatability with respect to the surface to be coated is improved. Accordingly, even when a thin film with a thickness of several micrometers is formed with a small amount of the liquid, a film having suppressed unevenness in thickness can be formed more favorably.

The fluorine content of the fluorine-based surfactant is preferably in a range of from 3% by mass to 40% by mass, more preferably in a range of from 5% by mass to 30% by mass, and still more preferably in a range of from 7% by mass to 25% by mass, with respect to the fluorine-based surfactant. When the fluorine content of the fluorine-based surfactant is within the above range, it is effective in terms of uniformity of the coating film thickness and liquid saving property, and excellent solubility in the radiation-sensitive composition can be achieved.

Examples of the fluorine-based surfactant include MEGAFAC F171, F172, F173, F176, F177, F141, F142, F143, F144, R30, F437, F475, F479, F482, F554, F780 and F781 (all trade names, manufactured by DIC Corporation), FLUORAD FC430, FC431 and FC171 (all trade names, manufactured by Sumitomo 3M Limited), and SURFLON S-382, SC-101, SC-103, SC-104, SC-105, SC-1068, SC-381, SC-383, S-393 and KH-40 (all trade names, manufactured by Asahi Glass Co., Ltd.).

Examples of the nonionic surfactant include: glycerol, trimethylolpropane, trimethylolethane, and ethoxylate or propoxylate of these compounds (for example, glycerol propoxylate, glycerine ethoxylate); polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate; sorbitan fatty acid esters such as PLURONIC L10, L31, L61, L62, 10R5, 17R2 and 25R2, and TETRONIC 304, 701, 704, 901, 904 and 150R1 (trade names, manufactured by BASF); and SORSPERSE 20000 (trade name, manufactured by The Lubrizol Corporation).

Specific examples of the cationic surfactant include: phthalocyanine derivatives such as EFKA-745 (trade name, manufactured by Morishita & Co., Ltd.); organosiloxane polymers such as KP341 (trade name, manufactured by Shin-Etsu Chemical Co., Ltd.); (meth)acrylic acid (co)polymers such as POLYFLOW No.75, No.90, No.95 (trade names, manufactured by Kyoeisha Chemical Co., Ltd.); and W001 (trade name, manufactured by Yusho Co., Ltd.).

Examples of the anionic surfactant include W004, W005 and W017 (trade names, manufactured by Yusho Co., Ltd.).

Specific examples of the silicone surfactant include TORAY SILICONE DC3PA, SH7PA, DC11PA, SH21PA, SH28PA, SH29PA, SH30PA and SH8400 (all trade names, manufactured by Dow Corning Toray Co., Ltd.), TSF-4440, 4300, 4445, 4460 and 4452 (all trade names, manufactured by Momentive Performance Materials Inc.), KP341, KP6001 and KP6002 (all trade names, manufactured by Shin-Etsu Chemical Co., Ltd.), and BYK 307, 323 and 330 (all trade names, manufactured by BYK Chemie).

These surfactants may be used, either singly or in combination of two or more kinds thereof.

The content of the surfactant is preferably in a range of from 0.001% by mass to 2.0% by mass, and more preferably in a range of from 0.005% by mass to 1.0% by mass, with respect to the total mass of the radiation-sensitive composition used in the invention.

(F-7) Other Additives

The radiation-sensitive composition may contain a co-sensitizer in order to further improve the sensitivity of a sensitizer or an initiator with respect to radiation, or to suppress polymerization inhibition of the photopolymerizable compound due to oxygen. In addition, known additives such as a diluent, a plasticizer, or a lipo-sensitizer may be optionally added in order to improve the physical properties of the cured film.

-Preparation of Titanium Black Dispersion-

The method of preparing the (A) pigment dispersion is not particularly limited. For example, the pigment dispersion may be prepared by subjecting a mixture of titanium black particles, a dispersant and an organic solvent to a dispersion treatment using a stirrer, a homogenizer, a high-pressure emulsification device, a wet grinding mill, a wet disperser, or the like. However, the preparation of the pigment dispersion is not limited to these methods.

The dispersion treatment may be conducted twice or more (multistage dispersion).

-Preparation of Radiation-sensitive Composition-

An embodiment of preparing the radiation-sensitive composition relating to the invention is not limited in particular. For example, the radiation-sensitive composition may be prepared by mixing the above-described (A) pigment dispersion, (B) polymerization initiator, (C) polymerizable compound, and a variety of additives that are optionally used in combination with these components.

When preparing the radiation-sensitive composition, it is preferable to filtrate the same after mixing the components in order in order to remove foreign substances or to reduce defects. The filter is not particularly limited, and those typically used for filtration can be used. Specific examples of the filter include filters made of a fluorine resin such as PTFE (polytetrafluoroethylene), a polyamide resin such as NYLON-6 and NYLON-6,6, a polyolefin resin (including high-density or ultrahigh molecular weight polyolefin) such as polyethylene and polypropylene (PP), or the like. Among these materials, polyamide resins such as NYLON-6 and NYLON-6, 6, and polypropylene (including high-density polypropylene) are preferable.

The pore size of the filter is suitably from 0.01 μm to 7.0 μm, preferably from 0.01 μm to 2.5 μm, and more preferably from 0.01 μm to 2.0 μm. When the pore size is within this range, it is possible to remove fine foreign substances, which inhibit the preparation of a uniform radiation-sensitive composition in the subsequent process, whereby a uniform, smooth and flat radiation-sensitive composition layer can be formed.

When a filter is used, different kinds of filters may be used in combination. In that case, the filtering with a first filter may be conducted either only once, or twice or more. Further, the first filter may be made of plural filters by combining filters having different pore sizes within the above range, and the first filtering may be conducted with plural filters. The pore size may be determined in view of nominal values provided by the manufacturers. Commercially available filters may be selected from various filters provided by, for example, Nihon Pall Ltd., Advantec Toyo Kaisha, Ltd., Nihon Entegris K.K. (former Nihon Microris K.K.), or Kitz Micro Filter Corporation.

A second filter may be formed from the same medium as the above-described first filter, and may be used for the filtering.

Further, for example, the filtering with a first filter may be conducted only for filtration of the pigment dispersion, and a second filtering may be conducted after mixing the pigment dispersion with other components to obtain a radiation-sensitive composition.

As described above, the (A) pigment dispersion and the radiation-sensitive composition are provided on a surface of a silicon substrate on which an imaging device unit is provided, and a side surface of a wall, and the like, to form a light-shielding film. Accordingly, the (A) pigment dispersion and the radiation-sensitive composition may be used without any particular limitation for the purpose of forming a light-shielding film that shields visible light.

«Light-shielding Film»

The light-shielding film of the present invention is a film that is formed from the radiation-sensitive composition as described above by spray coating. The surface roughness (Ra) of the light-shielding film after spray coating and drying is preferably in a range of from 10000 Å to 70000 Å, and in the present invention in the range of 15510 Å to 70000 Å. In the present specification, the surface roughness refers to a value obtained by carrying out measurement in accordance with JIS B 0601-1994.

In the present invention, the value of the surface roughness (Ra) is obtained by measurement with a contact profilometer DEKTAK 6M (trade name, manufactured by ULVAC, Inc.).

When the surface roughness is within the range, the light-shielding film of the present invention exhibits not

only an excellent visible light-shielding property but also an excellent visible light-antireflection property.

Further, in the case where the light-shielding film of the present invention is formed in a patterned manner, the amount of residues at the periphery region (an area of a silicon substrate on which the light-shielding film is not formed) is reduced.

The film thickness of the light-shielding film is not particularly limited. From the viewpoints of more efficiently achieving the effects of the present invention, the film thickness is preferably in a range of from 0.1 μm to 10 μm, more preferably in a range of from 0.3 μm to 5.0 μm, and most preferably in a range of from 0.5 μm to 3.0 μm. The pattern size of the light-shielding film is not particularly limited. From the viewpoints of more efficiently achieving the effects of the present invention, the pattern size is preferably 1000 μm or less, more preferably 500 μm or less, and most preferably 300 μm or less. The lower limit is preferably 1 μm.

The spectral characteristic of the light-shielding film of the present invention is not particularly limited, but a ratio of the optical density at a wavelength of 1200 nm ($OD_{1200}$) to the optical density at a wavelength of 365 nm ($OD_{365}$), represented by $OD_{1200}/OD_{365}$, is preferably in a range of from 0.5 to 3, from the viewpoints of further improving the visible light-shielding property, the balance of the light-shielding property of the visible region and the infrared region, and the like.

The value of optical density (OD) is obtained by measuring a transmittance of the film using UV-3600 (trade name, manufactured by Shimadzu Corporation) and converting the obtained transmittance (%T) in accordance with the following Equation B.

$$\text{Equation B: OD value} = -\text{Log}\ (\%T/100)$$

(Light-shielding Property)

In the invention, the optical density at a wavelength of λ nm is denoted by "$OD_{\lambda}$".

From the viewpoints of a balance of the light-shielding property in a visible region and the light-shielding property in an infrared region, and more efficient achievement of the effects of the present invention, it is preferable that the optical density of the light-shielding film satisfies the following conditions.

The ratio [$OD_{1200}/OD_{365}$] is more preferably from 1.0 to 2.5 and most preferably from 1.3 to 2.0.

The optical density [$OD_{1200}$] of the light-shielding film at a wavelength of 1200 nm is preferably from 1.5 to 10, and more preferably from 2 to 10.

The optical density ($OD_{365}$) is preferably from 1 to 7, and more preferably 2 to 6 at a wavelength of 365 nm of the light-shielding film.

The optical density of the light-shielding film at a wavelength range of 900 nm to 1300 nm is preferably from 2 to 10, more preferably from 2 to 9, and most preferably from 2 to 8.

The ratio [$OD_{900}/OD_{365}$] of the light-shielding film is preferably from 1.0 to 2.5, and more preferably from 1.1 to 2.5.

The ratio [$OD_{1100}/OD_{365}$] of the light-shielding film is preferably from 0.6 to 2.5, and more preferably from 0.7 to 2.5.

The ratio [$OD_{1300}/OD_{365}$] of the light-shielding film is preferably from 0.4 to 2.3, and more preferably from 0.5 to 2.0.

(Antireflection Property)

The antireflection property of the light-shielding film can be evaluated based on the reflectance thereof.

In the present invention, measurement of surface reflectance (%) is conducted at an incident angle of 5° in a visible wavelength range of 450 nm, with a spectrometer U-4100 (trade name, manufactured by Hitachi High-Technologies Corporation). The lower the reflectance is, the more favorable the antireflection property is.

For the purpose of using the light-shielding film in solid-state imaging devices, a surface reflectance of 4% or less is considered to be acceptable in practical use.

One of the specific embodiments of the light-shielding film of the present invention as described above is a light-shielding film for solid-state imaging devices.

«Production Method of Light-shielding Film»

The method of producing a light-shielding film of the present invention is a method of producing a light-shielding film for a solid-state imaging device, the solid-state imaging device comprising, on at least one surface of a silicon substrate, an imaging device unit comprising a light-receiving element, and a wall formed on the at least one surface of

the silicon substrate on which the imaging device unit is formed, the method comprising:

forming a radiation-sensitive layer by spraying a radiation-sensitive composition on the at least one surface of the silicon substrate on which the light-receiving element is formed and on the wall formed on the at least one surface of the silicon substrate on which the imaging device unit is formed; and
exposing the radiation-sensitive layer to light.

When a light-shielding film is formed only in a region where the light shielding film is necessary, and not formed in a region where a light-shielding film is not necessary, the exposure may be carried out in a patterned manner with respect to the radiation-sensitive layer formed on the entire surface including an imaging device unit portion, and subsequently developing the exposed radiation-sensitive layer (hereinafter, also referred to as a "development process"). For example, when it is desired to form a light-shielding film on the entire surface of the wall and on the bottom surface excluding the imaging device unit portion, a radiation-sensitive layer can be formed in a single process to surfaces having different angles, such as a bottom surface and a side surface.

According to the method of producing a light-shielding film of the invention, it is possible to form a light-shielding film, which exhibits an excellent light-shielding property and an excellent antireflection property with respect to visible light, on two surfaces positioned at different angles in a single process of forming a coating layer (a radiation-sensitive layer) in a simple manner. In addition, when a light-shielding film is formed in a patterned manner, the amount of residues (hereinafter, also referred to as "development residues") in a region other than the light-shielding film can be reduced.

In the following, the processes of the method of producing a light-shielding film of the present invention are described below.

-Radiation-sensitive Layer Formation Process-

In the radiation-sensitive layer formation process, a radiation-sensitive layer is formed on a silicon substrate by spraying the radiation-sensitive composition.

The application of a radiation-sensitive composition for forming a light-shielding film on a substrate is carried out by a spray coating method. The angle for spraying during the spray coating is preferably in the range of 20° to 160°, and more preferably in the range of 40° to 120°. The angle for spraying refers to an angle between a direction in which the radiation-sensitive composition is sprayed from an ejection port and a normal line to the substrate to be spray-coated. When the angle for spraying is within the range, a uniform coating film can be formed by a single process not only on a plane surface but also on a wall formed at an end of a plane substrate.

The thickness (dried thickness) of the radiation-sensitive composition that has been applied on the substrate is preferably in a range of from 0.35 μm to 3.0 μm, and more preferably in a range of from 0.50 μm to 2.5 μm, from the viewpoints of resolution and developability.

The radiation-sensitive composition that has been applied on the silicon substrate is typically dried at a temperature of from 70°C to 130°C for two to four minutes, thereby obtaining a radiation-sensitive layer.

-Exposure Process-

In the exposure process, the radiation-sensitive layer that has been formed in the radiation-sensitive layer formation process is subjected to pattern exposure, via a mask as necessary, and cured. When the exposure is performed using a mask, only a portion of the coating film that has been exposed to light is cured. Further, when a light-shielding film is formed on the entire surface of a side wall or the like, the exposure may be carried out on the entire surface of the radiation-sensitive layer.

The exposure is preferably performed by radiation irradiation, and examples of the radiant rays used for the exposure include ultraviolet rays such as g line, h line and i line, and a high pressure mercury lamp is more preferable. The irradiation intensity is preferably from 5 mJ to 3000 mJ, more preferably from 10 mJ to 2000 mJ, and most preferably from 10 mJ to 1000 mJ.

-Development Process-

Subsequent to the exposure process, the exposed radiation-sensitive layer is developed with, for example, an alkali developer to form a pattern. In the development process, the unexposed portion of the photosensitive layer is dissolved in an alkali aqueous solution while leaving the exposed portion. When the exposure is carried out on the entire surface, the development process may be omitted.

The developer is preferably an organic alkali developer since it does not damage underlying circuits or the like. The developing temperature is typically from 20°C to 30°C, and the time for development is typically from 20 seconds

to 240 seconds.

Examples of the developer include an aqueous alkali solution prepared by diluting an organic alkali compound with pure water such that the concentration of the organic alkali compound is from 0.001 % by mass to 10% by mass, and preferably from 0.01% by mass to 1 % by mass. Examples of the organic alkali compound that can be used for the developer include ammonia water, ethyl amine, diethyl amine, dimethylethanol amine, tetramethyl ammonium hydroxide, tetraethyl ammonium hydroxide, choline, pyrrole, piperidine, and 1,8-diazabicyclo[5.4.0]-7-undecene. When an alkali aqueous solution is used as a developer, generally, rinsing with pure water is performed after the development.

The production method of the light-shielding film of the invention may optionally include a curing process in which the pattern obtained after the development is cured by heating and/or exposure, in addition to the radiation-sensitive layer formation process, the exposure process, and the development process.

«Solid-State Imaging Device»

The solid-state imaging device of the present invention includes the light-shielding film of the present invention.

The imaging device may be a CCD or a CMOS.

In particular, a structure of a solid-state imaging device having metal electrodes for connection to a mounting substrate (hereinafter, also referred to as "a circuit board") on a surface opposite to a surface on which the imaging device unit is formed, such as those disclosed in JP-A No. 2009-99591 or JP-A No. 2009-158863, is suitable as the structure of the solid-state imaging device of the present invention.

In other words, a suitable embodiment of the solid-state imaging device of the present invention (in the present specification, also referred to as a "structure K") is a solid-state imaging device which has a silicon substrate having an imaging device unit on one surface (hereinafter, also referred to "as a first main surface") of the silicon substrate, metal electrodes which are provided on the other surface (hereinafter, also referred to as "a second main surface") of the silicon substrate and are electrically connected to the imaging device unit, and a light-shielding film of the present invention which is provided on the surface of the silicon substrate where the metal electrodes are provided and is patterned so as to expose at least a portion of the metal electrodes.

First, for a comparison purpose with respect to the above-described structure K, a conventional solid-state imaging device employing a wire bonding method is described.

Conventionally, the solid-state imaging device is connected to a circuit board by a wire bonding method.

Specifically, the solid-state imaging device is disposed on the circuit board, and electrodes for connection, which is provided on the imaging device unit side of the silicon substrate, and electrodes for connection, provided on the circuit board, are connected to each other by wires. In the structure employing the wire bonding method, the area of the bonding regions needs to be large and thus it is difficult to reduce the size of a camera module.

In contrast, the solid-state imaging device having the structure K is connected to a mounting substrate (hereinafter, also referred to as a "circuit board") via connection materials such as solder balls, rather than wires.

The connection between the solid-state imaging device having the structure K and the circuit board is performed by arranging the solid-state imaging device and the circuit board such that the metal electrodes and the electrodes for connection on the circuit board are opposite to each other, and by connecting the metal electrodes to the electrodes for connection via the connection materials (for example, see Figs. 2 and 3 described below).

Like the solid-state imaging device according to the structure K (without using the wires), since the space for wire bonding can be omitted by using the solid-state imaging device connected to the circuit board via the metal electrodes on the other surface, it is possible to significantly reducing the size of the camera module (for example, see "Reinforcement of CMOS image sensor business by self-manufacture of CMOS camera module for cellular phones", Toshiba Corporation New Release, [Online] October 1, 2007 [Searched on November 12, 2009], Internet<URL: http://www.toshiba.co.jp/about/press/2007_10/pr_j0102.htm>").

In the structure K, a protection insulating layer such as a solder resist layer may be formed on an overlying layer of the metal electrodes (a side apart from the silicon substrate) towards an underlying layer of the light-shielding film (a side close to the silicon substrate).

That is, the structure K may have a form in which the protection insulating layer is provided on the second main surface on which the metal electrodes are formed, and the protection insulating layer is patterned so as to expose at least a portion of the metal electrodes.

In the structure K, the meaning of "electrical connection" is not limited to direct connection, but includes indirect connection via peripheral circuits or the like.

Hereinafter, specific examples of the structure K are described with reference to Figs. 2 and 3, but the present invention is not limited thereto.

The same reference numeral is used to indicate the same part through Figs. 2 and 3.

In the description, the terms "on", "over", and "upper side" indicate a position remote from a silicon substrate 10, and the terms "down", "under", and "lower side" indicate a side close to the silicon substrate 10.

Fig. 2 is a schematic sectional view illustrating a configuration of a camera module having a solid-state imaging device relating to the specific example of the structure K.

A camera module 200 shown in Fig. 2 is connected to a circuit board 70 which is a mounting substrate via solder balls 60 which are connection members.

Specifically, the camera module 200 includes a solid-state imaging device substrate 100 having an imaging device unit on a first main surface of a silicon substrate, a glass substrate 30 (light-permeable substrate) disposed over the first main surface side of the solid-state imaging device substrate 100, an infrared light cut filter 42 disposed over the glass substrate 30, a lens holder 50 which is disposed over the glass substrate 30 and the infrared light cut filter 42, and has an imaging lens 40 in its inner space, and a light-shielding and electromagnetic shield 44 which is disposed to surround the periphery of the solid-state imaging device substrate 100 and the glass substrate 30. Each member is fixed with adhesives 20, 41 and 45.

In the camera module 200, incident light hv enters through the imaging lens 40, the infrared light cut filter 42 and glass substrate 30, in this order, and then reaches an imaging device unit of the solid-state imaging device substrate 100.

When the incident light hv having entered from the imaging lens 40 is reflected at a surface of the lens holder 50 that contacts the imaging lens 40, there is a possibility that the reflected light may cause a noise. In order to prevent the noise, it is necessary to suppress reflection at the bottom surface and at around the portion of the opening of the lens holder 50 that receives the incident light hv. As a result, the light-shielding film 18 of the invention is provided on the surface of the lens holder 50, which is an interface between the lens holder 50 and the imaging lens 40.

As described above, the light-shielding film 18 is formed on the surface of the lens holder 50, prior to installing the imaging lens 40 in the lens holder 50. Since the radiation-sensitive composition has excellent spray-coating suitability, the radiation-sensitive composition may be coated by a single process on three faces, i.e., an interface between the lens holder 50 and the under-infrared light cut filter 42, a side surface of the lens holder 50, and a surface around the imaging lens 40. If a radiation-sensitive composition layer is formed in an undesired region of the interface between the lens holder 50 and the under-infrared light cut filter 42, or the interface between the lens holder 50 and the above imaging lens 40, it can be removed by performing development after curing the layer at portions at which the light-shielding film 18 needs to be formed by performing pattern exposure.

The camera module 200 is connected to the circuit board 70 on the second main surface side of the solid-state imaging device substrate 100 via the solder balls 60 (connection materials).

Fig. 3 is an enlarged sectional view of the solid-state imaging device substrate 100 in Fig. 2.

The solid-state imaging device substrate 100 includes a silicon substrate 10 as a base body, imaging devices 12, an interlayer insulating layer 13, a base layer 14, a color filter 15R, a color filter 15G, a color filter 15B, an overcoat 16, micro lenses 17, an insulating layer 22, a metal electrode 23, a solder resist layer 24, an internal electrode 26, and an element surface electrode 27 as components. However, the solder resist layer 124 may be omitted.

First, the configuration of the first main surface of the solid-state imaging device substrate 100 is mainly described.

As shown in Fig. 2, the imaging device unit, including plural imaging devices 12 such as CCD or CMOS are arranged in a two-dimensional manner, is provided on the first main surface of the silicon substrate 10, which is a base body of the solid-state imaging device substrate 100.

On the imaging devices 12 in the imaging device unit, the interlayer insulating layer 13 is formed, and the base layer 14 is formed on the interlayer insulating layer 13. Further, the red color filter 15R, the green color filter 15G, and the blue color filter 15B (hereinafter, collectively referred to as "color filters 15" in some cases) are disposed on the base layer 14 so as to correspond to the imaging devices 12.

A light-shielding film (not shown) may be provided on the boundaries of the red color filter 15R, the green color filter 15G, and the blue color filter 15B, and the periphery of the imaging device unit. This light-shielding film may be manufactured by, for example, a known black color resist.

The overcoat 16 is formed on the color filters 15, and the micro-lenses 17 are formed on the overcoat 16 such that each of the micro-lenses corresponds to each of the imaging devices 12 (color filters 15).

Also, peripheral circuits (not shown) and the internal electrode 26 are provided on the periphery of the imaging device unit on the first main surface side, and the internal electrode 26 is connected to the imaging devices 12 via the peripheral circuits.

The element surface electrode 27 is formed on the internal electrode 26 via the interlayer insulating layer 13. In the interlayer insulating film 13 between the internal electrode 26 and the element surface electrode 27, a contact plug (not shown) for electrically connecting them to each other is formed. The element surface electrode 27 is used to apply voltages or to read signals via the contact plug and the internal electrode 26.

The base layer 14 is formed on the element surface electrode 27. The overcoat 16 is formed on the base layer 14. A pad opening is formed in the base layer 14 and the overcoat 16 formed on the element surface electrode 27, from which a portion of the element surface electrode 27 is exposed.

The above description is for the configuration of the first main surface side of the solid-state imaging device substrate 100.

In the first main surface side of the solid-state imaging device substrate 100, an adhesive 20 is applied in the vicinity of the imaging device unit, and the solid-state imaging device substrate 100 and the glass substrate 30 are attached to each other via the adhesive 20.

The silicon substrate 10 has a through-hole penetrating the silicon substrate 10, and a penetrating electrode, which is a portion of the metal electrode 23, is disposed in the through-hole. The imaging device unit is electrically connected to the circuit board 70 via the penetrating electrode.

Next, the configuration in the second main surface side of the solid-state imaging device substrate 100 is mainly described.

On the second main surface side, the insulating layer 22 is formed from the second main surface through the inner wall of the through-hole.

The metal electrode 23, which is patterned so as to cover from a region of the second main surface of the silicon substrate 10 to the inside of the through-hole, is provided on the insulating film 22. The metal electrode 23 is an electrode for connecting the imaging device unit of the solid-state imaging device substrate 100 to the circuit board 70.

The penetrating electrode is a part of the metal electrode 23 that is formed inside the through-hole. The penetrating electrode penetrates a portion of the silicon substrate 10 and a portion of the interlayer insulating layer, and reaches the lower side of the internal electrode 26, whereby the penetrating electrode is electrically connected to the internal electrode 26.

Further, on the second main surface side, the solder resist layer 24 (protection insulating layer), which covers the second main surface where the metal electrode 23 is formed, and has an aperture for exposing a portion of the metal electrode 23, is provided.

The solder ball 60 is provided on the exposed metal electrode 23 as a connection member, and the metal electrode 23 of the solid-state imaging device substrate 100 is electrically connected to the electrodes for connection (not shown) of the circuit board 70 via the solder ball 60.

In this way, although the configuration of the solid-state imaging device substrate 100 is described, each part excluding the light-shielding film 18 of the solid-state imaging device substrate 100 may be formed by a known method such as a method disclosed in paragraph [0033] to [0068] of JP-ANo. 2009-158863 or a method disclosed in paragraph [0036] to [0065] of JP-A No. 2009-99591.

Formation of the light-shielding film 18 may be performed in accordance with the method of producing a light-shielding film of the present invention, as described above.

The interlayer insulating film 13 is formed as a $SiO_2$ film or a SiN film by, for example, sputtering, CVD (Chemical Vapor Deposition), or the like.

The color filters 15 (15R, 15G, 15B) are formed by photolithography using, for example, a known color resist.

The overcoat 16 and the base layer 14 are formed by photolithography using, for example, a known resist for forming an organic interlayer film.

The micro lenses 17 are formed by photolithography using, for example, a styrene-based resin or the like.

The solder resist layer 24 is formed by photolithography using, for example, a known solder resist such as a phenol-based resin, a polyimide-based resin, or an amine-based resin.

The solder balls 60 are formed as, for example, Sn-Pb (eutectic), 95 Pb-Sn (high-leaded high-melting-point solder), Pb-free solder, using Sn-Ag, Sn-Cu, Sn-Ag-Cu, or the like. The solder ball 60 is formed as a sphere with, for example, a diameter of from 100 μm to 1000 μm (preferably, a diameter of from 150 μm to 700 μm).

The internal electrode 26 and the element surface electrode 27 are formed as a metal electrode of Cu or the like, by, for example, CMP (Chemical Mechanical Polishing), or photolithography and etching.

The metal electrode 23 is formed as a metal electrode of Cu, Au, Al, Ni, W, Pt, Mo, a Cu compound, a W compound, a Mo compound, or the like, by, for example, sputtering, photolithography, etching, or electrolytic plating. The metal electrode 23 may include a single layer structure or a multi-layer structure composed of two or more layers.

The film thickness of the metal electrode 23 is, for example, from 0.1 μm to 20 μm (preferably, from 0.1 μm to 10 μm).

The silicon substrate 10 is not particularly limited, but may use a silicon substrate which is thinned by grounding the back surface thereof. The thickness of the substrate is not limited, but may be a silicon wafer having the thickness of, for example, from 20 μm to 200 μm (preferably, from 30 μm to 150 μm).

The through-hole of the silicon substrate 10 is formed by, for example, photolithography and RIE (Reactive Ion Etching).

Although the solid-state imaging device substrate 100, which is a specific example of the above-described structure K, is described with reference to Figs. 2 and 3, the structure K is not limited to the configuration shown in Figs. 2 and 3, and is not particularly limited as long as the configuration has a metal electrode and a light-shielding film on the other surface side of the structure K.

EXAMPLES

Hereinafter, the present invention is described in more detail with respect to the specific examples. The present invention is not limited to these Examples, as long as the invention does not depart from its purport. Unless otherwise specified, the term "part" is based on mass, and the term "room temperature" refers to 25°C.

(Preparation of Titanium Black)

100 g of titanium oxide (particle size: 15 nm, MT-150A, trade name, manufactured by Tayca Corporation), 25 g of silica particles (BET surface area: 300 $m^2$/g, AEROPERL, registered trademark, 300/30, manufactured by Evonic Industries), and 100 g of DISPERBYK 190 (trade name, manufactured by BYK Chemie) were weighed and 71 g of ion-exchange water were added to the mixture, and then mixed with a mixer (MAZERSTAR KK-400, trade name, manufactured by Kkurabo Industries Ltd.) for 20 minutes under the number of revolutions of 1360 rpm and the number of rotation of 1047 rpm, thereby obtaining a uniform mixture aqueous solution. Thereafter, the obtained aqueous solution was placed in a quartz container, and then heated at 920°C in an oxygen atmosphere using a compact size rotary kiln (manufactured by Motoyama), and then nitridation reduction was performed by purging with nitrogen and allowing an ammonia gas to flow for 5 hours at 100 ml/min under the same temperature. After the completion of the treatment, the recovered powder was pulverized with a mortar to obtain a powder of titanium black A containing Si atoms (dispersed material).

Further, titanium black B, titanium black C and titanium black X were obtained in the same manner as titanium black A, except that the amount of the silica particles AEROPERL used in the preparation of titanium black A was changed to 12.5 g, 10 g, and 5 g, respectively.

(Synthesis of Dispersant 1)

In a 500 ml three-necked flask, 600.0 g of ε-caprolactone and 22.8 g of 2-etheyl-1-hexanol were placed, and then the mixture was stirred to dissolve the compounds while introducing nitrogen into the flask. Then, 0.1 g of monobutyl tin oxide were added to the resultant solution and heated at 100 °C. 8 hours after, the reaction mixture was cooled to 80°C after confirming the disappearance of raw materials by gas chromatography. Further, 0.1 g of 2,6-di-t-butyl-4-methylphenol were added, and 27.2 g of 2-methacryloyoxyethylisocyanate were subsequently added. 5 hours after, the reaction mixture was cooled to room temperature after confirming the disappearance of raw materials by 1H-NMR. Through these processes, 200 g of solid-state precursor M1 (having the following structure) were obtained. Identification of M1 was carried out by 1H-NMR, IR and mass analysis.

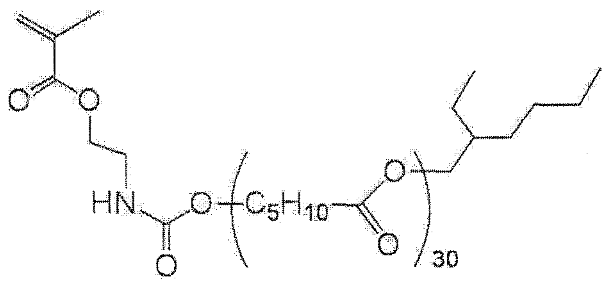

M1

30.0 g of the solid-state precursor M1, 70.0 g of NK ESTER CB-1 (2-methacryloyoxyethylphtharic acid, manufactured by Shin-Nakamura Chemical Co., Ltd.), 2.3 g of dodecylmercaptan, and 233.3 g of propyleneglycol monomethylether acetate were placed in a nitrogen-substituted three-necked flask and stirred with a stirrer (THREE-ONE MOTOR, trade name, manufactured by Shinto Scientific Co., Ltd.), and the temperature in the flask was elevated to 75°C by heating, while allowing a nitrogen gas to flow in the flask. To the resultant mixture, 0.2 g of dimethyl 2,2-azobis (2-methylpropionate) (V-601, trade name, manufactured by Wako Pure Chemical Industries, Ltd.) was added and heated while heating at 75°C for 2 hours. After a lapse of 2 hours, 0.2 g of V-601 was additionally added and heated while stirring for 3 hours. As a result, a 30% solution of the dispersant 1, as described below, was obtained.

Dispersant 1

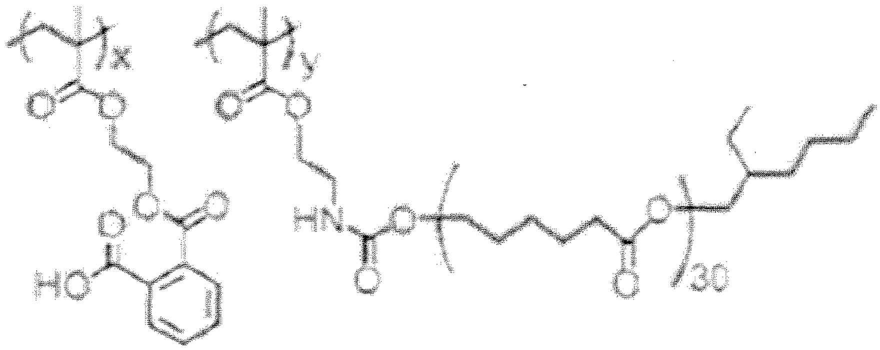

The composition ratio, the acid value and the weight-average molecular weight (Mw) of dispersant 1 are described below. The weight-average molecular weight is a value calculated by gel permeation chromatography (GPC) with polystyrene standard. The GPC was conducted using KLC-8020GPC (trade name, manufactured by Tosoh Corporation) with columns (TSK GEL SUPER HZM-H, TSK GEL SUPER HZ 4000, and TSK GEL SUPER HZ 200, all trade names, manufactured by Tosoh Corporation).

- Composition ratio: x = 35 (% by mass), y = 65 (% by mass)
- Acid value: 80 mg KOH/g
- Mw: 30,000

Examples 1 to 3 and Comparative Examples 1 to 3

1. Preparation of Titanium Black Dispersion Composition

The components shown in the following composition 1 were mixed with a stirrer (EUROSTAR, trade name, manufactured by IKA Japan K.K) for 15 minutes, thereby obtaining dispersion a.

(Composition 1)

- (a-1) Dispersed material: Titanium black A prepared above 25 parts
- (a-2) Dispersant: 30% solution of Dispersant 1 25 parts
- (a-3) Organic Solvent: Propyleneglycol monomethylether acetate 50 parts

The obtained dispersion a was subjected to a dispersion treatment with a disperser (ULTRA APEX MILL UAM 015, trade name, manufactured by Kotobuki Industries, Co., Ltd.) under the following conditions, thereby obtaining titanium black dispersion composition A (pigment dispersion) used for the formation of a light-shielding film of Example 1.

(Dispersion Conditions)

- Bead size: ϕ 0.05 mm
- Filling rate: 75% by volume
- Mill circumferential velocity: 8 m/sec
- Amount of mixture for dispersion treatment: 500 g
- Circuit flow rate (pump supply quantity): 13 kg/hour
- Treatment liquid temperature: 25°C to 30°C
- Cooling water: tap water
- Beads mill circular pathway inner volume: 0.15 liters
- Number of passes: 90 passes

Titanium black dispersion liquids B, C, X and Y, of Examples 2, 3 and Comparative Examples 1 and 2, were

obtained in the same manner as the Titanium black dispersion composition A, except that titanium black A used was replaced with titanium black B, C, X and TITANIUM BLACK 13M-T (trade name, manufactured by Mitsubishi Materials Corporation), respectively.

1. Preparation of Black Radiation-sensitive Composition

(Preparation of Binder Solution 1)

In a 1000-ml three-necked flask, 159 g of 1-methoxy-2-propanol were placed and heated to 85°C under a nitrogen stream. A solution prepared by adding 63.4 g of benzyl methacrylate, 72.3 g of methacrylic acid and 4.15 g of V-601 (trade name, manufactured by Wako Pure Chemical Industries, Ltd.) to 159 g of 1-methoxy-2-propanol was dropped to the flask over 2 hours. After the completion of the dropping, the reaction mixture was further heated for 5 hours for reaction.

Thereafter, heating was stopped and a solution containing a copolymer of benzyl methacrylate/methacrylic acid (molar ratio: 30/70) was obtained.

Next, 120.0 g of the obtained copolymer solution was transferred to a 300-ml three-necked flask. To the flask, 16.6 g of glycidyl methacrylate and 0.16 g of p-methoxyphenol were added and dissolved by stirring. After dissolving, 3.0 g of triphenyl phosphine were added and heated to 100°C to cause addition reaction. After confirming the disappearance of glycidyl methacrylate by gas chromatography, the heating was stopped. To the reaction solution, 184 g of 1-methoxy-2-propanol were added, thereby obtaining a binder solution 1 having a weight-average molecular weight of 12,000 (polyethylene conversion value measured by GPC), an acid value of 35 mg KOH/g, and a solid content of 30% by mass.

(Preparation of Black Radiation-sensitive Composition A)

The following components (composition 2) were mixed with a stirrer and filtrated with a filter, whereby black radiation-sensitive composition A of Example 1 was prepared.

(Composition 2)

· (A) Titanium black dispersion composition A 50 parts
· (F) Alkali soluble resin: binder solution 1 17.0 parts
· (B) Polymerizable compound: KAYARD DPHE
(manufactured by Nippon Kayaku Co., Ltd) 5.0 parts
· (C) Polymerization initiator: IRGACURE OXE 02 (manufactured by BASF) 2.5 parts
· (F-4) Polymerization inhibitor: p-methoxyphenol 0.003 parts
· (F-6) Surfactant: MEGAFAC F 781
(fluorine-based surfactant, manufactured by DIC Corporation) 0.01 parts
. Organic solvent: Propyleneglycol monomethylether acetate 10 parts
· Organic solvent: Cyclohexanone 10 parts

(Preparation of Black Radiation-sensitive Compositions B, C, X and Y)

Black radiation-sensitive compositions B, C, X and Y of Examples 2 and 3, and Comparative Examples 1 and 2 were prepared in the same manner as the black radiation-sensitive composition A, except that the titanium black dispersion composition A was replaced with titanium black dispersion compositions B, C, X and Y, respectively.

The viscosities of the black radiation-sensitive compositions A, B, C, X and Y were 6.1 mPa·s (A), 6.5 mPa·s (B), 6.3 mPa·s (C), 7.0 mPa·s (X), and 6.6 mPa·s (Y), respectively.

-Evaluation of Black Radiation-sensitive Compositions-

Evaluation of the black radiation-sensitive compositions obtained above was conducted in terms of the Si/Ti ratio of the dispersed material and the particle size of the dispersed material.

< Si/Ti Ratio >

Each of the samples, divided from each of the black radiation-sensitive compositions A, B, C, X and Y, was placed on a commercially available quartz boat and subjected to a heat treatment at 500°C for 60 minutes under an oxygen flow of 100 ml/min with an electric furnace. The Si atomic weight and the Ti atomic weight of the powder obtained by the heat treatment was measured with a digital scanning electron microscope (S-4800, trade name, manufactured by Hitachi High-Technologies Corporation) and INCA ENERGY PENTA FETx3 (trade name, manufactured by Oxford Instruments), and the Si/Ti ratio was calculated.

The values of Si/Ti ratio of the dispersed materials contained in the black radiation-sensitive compositions are shown in Table 1 below.

<Particle Size of Dispersed Material>

Each of the black radiation-sensitive compositions A, B, C, X and Y was diluted 100 times with propyleneglycol monomethylether acetate as a solvent, and dropped on a carbon foil and dried. Then, the resultant dry carbon foil was observed with a TEM to measure an average particle size of the dispersed material.

The average particle size of the dispersed material contained in each of the black radiation-sensitive compositions, and the percentage of particles of from 15 nm to 30 nm are shown in Table 1 below.

Table 1

| Black Composition | Average particle size of Dispersed material | Percentage of particles of 15 nm to 30nm | Si/Ti Ratio |
|---|---|---|---|
| A | 20 nm | 98% | 0.27 |
| B | 21 nm | 96% | 0.41 |
| C | 21 nm | 95% | 0.20 |
| X | 32 nm | 88% | 0.18 |
| Y | 75 nm | 70% | 0 |

(Coating Liquid 1 for forming Light-shielding Film)

The black composition A. immediately after the preparation thereof, was placed in a cup of a spray coating device to prepare a coating liquid for forming light-shielding film. The coating liquid was applied onto a glass substrate under the following conditions, thereby forming a light-shielding film 1 (light-shielding film of Example 1).

Spray coating device: PS-268, trade name, manufactured by GS1 Creos Corporation
Air pressure condition: 3000 cc/minute
Coating amount: 0.2 cc/minute
Nozzle diameter: 0.4 mm

The ejection port for spraying was placed in a vertical manner with respect to a surface of the glass substrate to be coated.

Distance between spray nozzle (ejection port) and glass substrate: 3 cm
Angle for spraying*: 90°
(* the angle formed between a direction of spraying and a normal line to the glass substrate)

The spray coating was conducted until the average film thickness of the coated portion was 2.5 μm. After the coating, the coated portion was heated with a hot plate at 120°C for 2 minutes.

Light-shielding films of Examples 2 and 3, and Comparative Examples 1 and 2 were prepared in the same manner as the method described above, except that the black composition A used in the coating liquid 1 for forming a light-shielding film was replaced with the black compositions B, C, X and Y, respectively.

(Preparation of Light-shielding Film of Comparative Example 3)

The black composition B obtained above was applied by spin coating onto a substrate to a thickness of 2.5 μm, and was heated with a hot plate at 120°C to obtain a light-shielding film of Comparative Example 3.

The surface roughness of the light-shielding film of Comparative Example 3, which was formed by spin coating, was 5326 Å.

(Evaluation of Clogging in Spray Coating)

Spray coating was carried out with each of the black compositions A, B, C, X and Y under the following conditions, and the occurrence of clogging was evaluated.

Spray Coating Device: PS-268, trade name, manufactured by GS1 Creos Corporation

A black composition to be evaluated was placed in a cup of the above-described spray coating device, and was left to stand at 25°C for 96 hours. Then, spray coating was conducted under the following conditions using the spray coating device, and the occurrence of clogging was evaluated.

Air pressure condition: 3000 cc/minute
Coating amount: 0.2 cc/minute
Nozzle diameter: 0.4 mm

(Measurement of surface reflectance)

The surface reflectance (%) of each sample was measured at a wavelength of 450 nm (incident angle of 5°) with a spectrophotometer (U-4100, trade name, manufacture by Hitachi High-Technologies Corporation).

When the surface reflectance is 4% or less, especially in the case where the light-shielding film is used for a solid-state imaging device, it is regarded as acceptable in practical use.

The evaluation results of the clogging during formation of the light-shielding films of Examples 1, 2 and 3, and Comparative Examples 1, 2 and 3, and the surface reflectance of the light-shielding films, are shown below.

(Light-shielding Property)

The transmittance of each sample was measured at a wavelength of 550 nm with a spectrophotometer (U-4100, trade name, manufacture by Hitachi High-Technologies Corporation). The transmittance is used as an indicator of the light-shielding property.

Table 2

| | Average Particle Size of Dispersed material (nm) | Percentage of Particles of 15 to 30 nm | Si/Ti Ratio | Occurrence of Clogging | Light-shielding Property (Transmittance %) | Surface Reflectance |
|---|---|---|---|---|---|---|
| Example 1 | 20 | 97% | 0.26 | No | 0.004 | 0.39 |
| Example 2 | 22 | 96% | 0.40 | No | 0.003 | 0.34 |
| Example 3 | 21 | 94% | 0.21 | No | 0.007 | 0.37 |
| Comparative Example 1 | 32 | 88% | 0.35 | Yes | 0.003 | 0.35 |
| Comparative Example 2 | 75 | 71% | 0 | Yes | 0.004 | 0.36 |
| Comparative Example 3 | 22 | 96% | 0.41 | - | 0.001 | 5% or more |

From the results shown in Table 2, it is seen that the light-shielding films of the present invention exhibit a favorable spray-coating suitability and a favorable antireflection property. In contrast, in spite of the use of the same

black radiation-sensitive composition as those used in the present invention, the light-shielding film formed by a spin coating method exhibits an antireflection property below the acceptable level for practical use.

As previously described, the light-shielding film of Comparative Example 3, which was formed by spin coating, has a surface roughness of 5326 Å, which is outside of a preferable range in the present invention. Accordingly, it is seen that the light-shielding film of Comparative Example 3 is inferior in terms of antireflection property as compared with the light-shielding films of Examples 1 to 3, which were formed by a spray coating method.

[Examples 4 to 8]

Coating films were prepared in the same manner as Example 2, except that the angle for spraying was changed from 90° to 20°, 35°, 62°,118° and 152°, respectively, by adjusting the shape of a nozzle (ejection port) of the spray coating device. The coating films were designated as Examples 4, 5, 6, 7 and 8, respectively. The surface reflectance of the films was measured and the results are shown in the following Table 3, together with the results of Example 2. The surface roughness of the coating film of Example 4, in which the angle for spraying was 20°, was 75211 Å.

Table 3

| | Angle for Spraying (°) | Light-shielding Property (Transmittance %) | Surface Reflectance (%) |
|---|---|---|---|
| Example 2 | 90 | 0.003 | 0.34 |
| Example 4 | 20 | 0.002 | 0.10 |
| Example 5 | 35 | 0.001 | 0.12 |
| Example 6 | 62 | 0.001 | 0.15 |
| Example 7 | 118 | 0.004 | 0.40 |
| Example 8 | 152 | 0.007 | 0.70 |

As is apparent from Table 3, it is seen that it was possible to carry out uniform coating within a range in which the angle of the ejection port of the spray nozzle was from 20° to 160°, and it was possible to obtain a light-shielding film having a favorable surface reflectance. In addition, it was also found that a slight degree of coating unevenness occurred when the angle for spraying was 35°. Accordingly, it can be concluded that the angle for spraying is preferably from 40° to 120°.

[Example 9 to Example 13]

Samples having different surface roughnesses were prepared by modifying the distance between the nozzle (ejection port) of the spray coating device and the glass substrate of Example 2 (3 cm) to 10 cm, 5 cm, 4 cm, 2 cm and 1 cm, respectively. The obtained samples were designated as Examples 9, 10, 11, 12 and 13, respectively.

The surface roughness Ra was measured with a contact profilometer (DEKTAK 6M, trade name, manufactured by ULVAC, Inc.)

The measurement results of the surface roughness Ra and the surface reflectance are shown in the following Table 4 together with the results of Example 2.

Table 4

| | Surface Roughness Ra (Å) | Light-shielding Property (Transmittance %) | Surface Reflectance (%) |
|---|---|---|---|
| Example 2 | 19,730 | 0.003 | 0.34 |
| Example 9 | 58,700 | 0.001 | 0.11 |
| Example 10 | 34,220 | 0.009 | 0.19 |
| Example 11 | 28,160 | 0.003 | 0.33 |
| Example 12 | 15,510 | 0.006 | 0.59 |
| Example 13 | 12,240 | 0.001 | 3.82 |

As shown in Table 4, it is seen that the light-shielding films of the present invention have a surface roughness

of from 10,000 Å to 70,000 Å, which results in a favorable surface reflectance.

## Claims

1. A light-shielding film for a solid-state imaging device, the solid-state imaging device comprising, on at least one surface of a substrate, an imaging device unit comprising a light-receiving element and a wall (114) formed on the surface on which the imaging device unit is located, the light-shielding film (18) being formed by spraying, on a surface of the substrate on which the light-receiving element is located and on a surface of the wall formed on the surface of the substrate on which the imaging device unit is located, a radiation sensitive composition comprising:

    (A) a pigment dispersion comprising a dispersed material comprising a black pigment, a dispersant, and an organic solvent, 90% or more of the dispersed material having a particle diameter of from 15 nm to 30 nm;
    (B) a polymerizable compound; and
    (C) a polymerization initiator;

    **characterised in that**
    the light-shielding film has a surface roughness (Ra) in the range of from 15,510 Å to 70,000 Å.

2. The light-shielding film for a solid-state imaging device according to claim 1, wherein the thickness of the light-shielding film is from 0.3 μm to 5.0 μm.

3. The light-shielding film for a solid-state imaging device according to claim 1 or 2, wherein the viscosity of the radiation-sensitive composition at 25°C is from 2 mPa·s to 50 mPa·s.

4. The light-shielding film for a solid-state imaging device according to any one of claims 1 to 3, wherein a surface roughness (Ra) of the light-shielding film is in the range of from 15,510 Å to 58,700 Å.

5. The light-shielding film for a solid-state imaging device according to any one of claims 1 to 4, wherein the dispersed material comprises titanium black.

6. The light-shielding film for a solid-state imaging device according to any one of claims 1 to 5, wherein the dispersed material comprises titanium black and Si atoms, and the content ratio (Si/Ti) of Si atoms to Ti atoms in the dispersed material is from 0.20 to 0.50.

7. The light-shielding film for a solid-state imaging device according to any one of claims 1 to 6, wherein the polymerization initiator (C) is an oxime ester compound.

8. The light-shielding film for a solid-state imaging device according to any one of claims 1 to 7, wherein the polymerization initiator (C) is ethanone, 1-[9-ethyl-6-(2-methylbenzoyl)-9H-carbazol-3-yl],1-(O-acetyl oxime).

9. A method of producing a light-shielding film for a solid-state imaging device, the solid-state imaging device comprising, on at least one surface of a silicon substrate, an imaging device unit comprising a light-receiving element, and a wall (114) formed on the surface of the silicon substrate on which the imaging device unit is located, the method comprising:

    forming a radiation-sensitive layer (18) by spraying, on a surface of the silicon substrate and on a surface of the wall, a radiation-sensitive composition comprising:

        (A) a pigment dispersion comprising a dispersed material comprising a black pigment, 90% or more of the dispersed material having a particle diameter of from 15 nm to 30 mn;
        (B) a polymerizable compound; and
        (C) a polymerization initiator; and

    exposing the radiation-sensitive layer to light

    **characterised in that**
    the viscosity of the radiation-sensitive composition at 25°C is from 2 mPa·s to 15 mPa·s, and a spray angle in the

spraying step is from 20° to 160° with respect to an ejection port of a spray nozzle.

**10.** The method of producing a light-shielding film for a solid-state imaging device according to claim 9, wherein a spray angle in the spraying step is from 40° to 120° with respect to an ejection port of a spray nozzle.

**11.** The method of producing a light-shielding film for a solid-state imaging device according to claim 9 or claim 10, wherein a surface roughness (Ra) of the light-shielding film is in the range of from 10,000 Å to 70,000 Å.

**12.** The method of producing a light-shielding film for a solid-state imaging device according to any one of claims 9 to 11, wherein the polymerization initiator (C) is an oxime ester compound.

**13.** The method of producing a light-shielding film for a solid-state imaging device according to any one of claims 9 to 12, wherein the polymerization initiator (C) is ethanone, 1-[9-ethyl-6-(2-methylbenzoyl)-9H-carbazol-3-yl],1-(O-acetyl oxime).

**14.** The method of producing a light-shielding film for a solid-state imaging device according to any one of claims 9 to 13, wherein the exposing of the radiation-sensitive layer is a process of exposing the radiation-sensitive layer in a patterned manner, and the method further comprises developing the radiation-sensitive layer after the exposing.

**15.** A solid-state imaging device (100) comprising, on at least one surface, an imaging device unit comprising a light-receiving element, a wall formed on the surface on which the imaging device unit is located, and the light-shielding film (18) according to any one of claims 1 to 8 formed on a surface of a silicon substrate and on the wall.

**16.** The solid-state imaging device according to claim 15, comprising:

a silicon substrate comprising, on at least one surface, an imaging device unit comprising a light-receiving element and a wall formed on the surface on which the imaging device unit is located;
a light-shielding film according to any one of claims 1 to 8 provided on a surface on which the imaging device unit of the silicon substrate is located and patterned such that at least a part of the imaging device unit is exposed; and
a light-shielding film according to any one of claims 1 to 8 formed on the wall formed on the surface on which the imaging device unit is located.

## Patentansprüche

**1.** Lichtabschirmender Film für eine Festphasen-Bildgebungsvorrichtung, wobei die Festphasen-Bildgebungsvorrichtung auf zumindest einer Oberfläche eines Substrats eine Bildgebungsvorrichtungseinheit, umfassend ein lichtaufnehmendes Element, und eine Wand (114) umfasst, gebildet auf der Oberfläche, auf der die Bildgebungsvorrichtungseinheit lokalisiert ist,
worin der lichtabschirmende Film (18) gebildet ist durch Sprühen, auf eine Oberfläche des Substrats, auf der das lichtaufnehmende Element lokalisiert ist, und auf eine Oberfläche der Wand, die auf der Oberfläche des Substrats gebildet ist, auf der die Bildgebungsvorrichtungseinheit lokalisiert ist, einer strahlungsempfindlichen Zusammensetzung, umfassend:

(A) eine Pigmentdispersion, umfassend ein dispergiertes Material, welches ein schwarzes Pigment umfasst, ein Dispergiermittel und ein organisches Lösungsmittel, worin 90 % oder mehr des dispergierten Materials einen Partikeldurchmesser von 15 nm bis 30 nm aufweist;
(B) eine polymerisierbare Verbindung; und
(C) einen Polymerisationsinitiator;

**dadurch gekennzeichnet, dass** der lichtabschirmende Film eine Oberflächenrauheit (Ra) im Bereich von 15.510 Å bis 70.000 Å aufweist.

**2.** Lichtabschirmender Film für eine Festphasen-Bildgebungsvorrichtung gemäß Anspruch 1, worin die Dicke des lichtabschirmenden Films von 0,3 μm bis 5,0 μm beträgt.

**3.** Lichtabschirmender Film für eine Festphasen-Bildgebungsvorrichtung gemäß Anspruch 1 oder 2, worin die Viskosität

der strahlungsempfindlichen Zusammensetzung bei 25°C von 2 mPa·s bis 50 mPa·s beträgt.

**4.** Lichtabschirmender Film für eine Festphasen-Bildgebungsvorrichtung gemäß irgendeinem der Ansprüche 1 bis 3, worin die Oberflächenrauheit (Ra) des lichtabschirmenden Films im Bereich von 15.510 Å bis 58.700 Å liegt.

**5.** Lichtabschirmender Film für eine Festphasen-Bildgebungsvorrichtung gemäß irgendeinem der Ansprüche 1 bis 4, worin das dispergierte Material Titanschwarz umfasst.

**6.** Lichtabschirmender Film für eine Festphasen-Bildgebungsvorrichtung gemäß irgendeinem der Ansprüche 1 bis 5, worin das dispergierte Material Titanschwarz und Si-Atome umfasst, und worin das Mengenverhältnis (Si/Ti) von Si-Atomen zu Ti-Atomen in dem dispergierten Material von 0,20 bis 0,50 beträgt.

**7.** Lichtabschirmender Film für eine Festphasen-Bildgebungsvorrichtung gemäß irgendeinem der Ansprüche 1 bis 6, worin der Polymerisationsinitiator (C) eine Oximesterverbindung ist.

**8.** Lichtabschirmender Film für eine Festphasen-Bildgebungsvorrichtung gemäß irgendeinem der Ansprüche 1 bis 7, worin der Polymerisationsinitiator (C) Ethanon, 1-[9-Ethyl-6-(2-methylbenzoyl)-9H-carbazol-3-yl], 1-(O-Acetyloxim) ist.

**9.** Verfahren zur Herstellung eines lichtabschirmenden Films für eine Festphasen-Bildgebungsvorrichtung, worin die Festphasen-Bildgebungsvorrichtung auf zumindest einer Oberfläche eines Siliciumsubstrats eine Bildgebungsvorrichtungseinheit, umfassend ein lichtaufnehmendes Element, und eine Wand (114), die auf der Oberfläche des Siliciumsubstrats gebildet ist, auf der die Bildgebungsvorrichtungseinheit lokalisiert ist, umfasst, wobei das Verfahren umfasst:

Bilden einer strahlungsempfindlichen Schicht (18) durch Sprühen, auf eine Oberfläche des Siliciumsubstrats und auf eine Oberfläche der Wand, einer strahlungsempfindlichen Zusammensetzung, umfassend:

(A) eine Pigmentdispersion, umfassend ein dispergiertes Material, welches ein schwarzes Pigment umfasst, ein Dispergiermittel und ein organisches Lösungsmittel, worin 90 % oder mehr des dispergierten Materials einen Partikeldurchmesser von 15 nm bis 30 nm aufweist;
(B) eine polymerisierbare Verbindung; und
(C) einen Polymerisationsinitiator; und

Belichten der strahlungsempfindlichen Schicht;
**dadurch gekennzeichnet, dass** die Viskosität der strahlungsempfindlichen Zusammensetzung bei 25°C von 2 mPa·s bis 15 mPa·s beträgt und dass der Sprühwinkel im Sprühschritt von 20° bis 160° in Bezug auf den Auslass einer Sprühdüse beträgt.

**10.** Verfahren zur Herstellung eines lichtabschirmenden Films für eine Festphasen-Bildgebungsvorrichtung gemäß Anspruch 9, worin der Sprühwinkel im Sprühschritt von 40° bis 120° in Bezug auf den Auslass einer Sprühdüse beträgt.

**11.** Verfahren zur Herstellung eines lichtabschirmenden Films für eine Festphasen-Bildgebungsvorrichtung gemäß Anspruch 9 oder Anspruch 10, worin die Oberflächenrauheit (Ra) des lichtabschirmenden Films im Bereich von 10.000 Å bis 70.000 Å liegt.

**12.** Verfahren zur Herstellung eines lichtabschirmenden Films für eine Festphasen-Bildgebungsvorrichtung gemäß irgendeinem der Ansprüche 9 bis 11, worin der Polymerisationsinitiator (C) eine Oximesterverbindung ist.

**13.** Verfahren zur Herstellung eines lichtabschirmenden Films für eine Festphasen-Bildgebungsvorrichtung gemäß irgendeinem der Ansprüche 9 bis 12, worin der Polymerisationsinitiator (C) Ethanon, 1-[9-Ethyl-6-(2-methylbenzoyl)-9H-carbazol-3-yl], 1-(O-Acetyloxim) ist.

**14.** Verfahren zur Herstellung eines lichtabschirmenden Films für eine Festphasen-Bildgebungsvorrichtung gemäß irgendeinem der Ansprüche 9 bis 13, worin das Belichten der strahlungsempfindlichen Schicht ein Prozess zum Belichten der strahlungsempfindlichen Schicht auf gemusterte Weise ist und das Verfahren ferner das Entwickeln der strahlungsempfindlichen Schicht nach der Belichtung umfasst.

**15.** Festphasen-Bildgebungsvorrichtung (100), umfassend auf zumindest einer Oberfläche eine Bildgebungsvorrichtungseinheit, die ein lichtaufnehmendes Element umfasst, eine Wand, die auf der Oberfläche gebildet ist, auf der die Bildgebungsvorrichtungseinheit lokalisiert ist, und den lichtabschirmenden Film (18) gemäß irgendeinem der Ansprüche 1 bis 8, gebildet auf einer Oberfläche eines Siliciumsubstrats und auf der Wand.

**16.** Festphasen-Bildgebungsvorrichtung gemäß Anspruch 15, umfassend:

ein Siliciumsubstrat, das auf zumindest einer Oberfläche eine Bildgebungsvorrichtungseinheit, umfassend ein lichtaufnehmendes Element, und eine Wand, gebildet auf der Oberfläche, auf der die Bildgebungsvorrichtungseinheit lokalisiert ist, umfasst;
einen lichtabschirmenden Film gemäß irgendeinem der Ansprüche 1 bis 8, vorgesehen auf einer Oberfläche, auf der die Bildgebungsvorrichtungseinheit des Siliciumsubstrats lokalisiert ist, und der so gemustert ist, dass zumindest ein Teil der Bildgebungsvorrichtungseinheit freigelegt ist; und
einen lichtabschirmenden Film gemäß irgendeinem der Ansprüche 1 bis 8, gebildet auf der Wand, die auf der Oberfläche gebildet ist, auf der die Bildgebungsvorrichtungseinheit lokalisiert ist.

## Revendications

**1.** Film de protection contre la lumière pour un dispositif d'imagerie à semi-conducteur, le dispositif d'imagerie à semi-conducteur comprenant, sur au moins une surface d'un substrat, une unité de dispositif d'imagerie comprenant un élément récepteur de lumière et une paroi (114) formée sur la surface sur laquelle l'unité du dispositif d'imagerie est située,
le film de protection contre la lumière (18) étant formé par pulvérisation, sur une surface du substrat sur laquelle l'élément récepteur de lumière est situé et sur une surface de la paroi formée sur la surface du substrat sur laquelle l'unité du dispositif d'imagerie est située, d'une composition sensible au rayonnement comprenant :

(A) une dispersion de pigment comprenant un matériau dispersé comprenant un pigment noir, un dispersant et un solvant organique, 90 % ou plus du matériau dispersé ayant un diamètre de particule de 15 nm à 30 nm ;
(B) un composé polymérisable ; et
(C) un initiateur de polymérisation ;

**caractérisé en ce que**
le film de protection contre la lumière a une rugosité de surface (Ra) comprise dans la plage allant de 15 510 Å à 70 000 Å.

**2.** Film de protection contre la lumière pour un dispositif d'imagerie à semi-conducteur selon la revendication 1, dans lequel l'épaisseur du film de protection contre la lumière est de 0,3 μm à 5,0 μm.

**3.** Film de protection contre la lumière pour un dispositif d'imagerie à semi-conducteur selon la revendication 1 ou 2, dans lequel la viscosité de la composition sensible au rayonnement à 25 °C est de 2 mPa.s à 50 mPa.s.

**4.** Film de protection contre la lumière pour un dispositif d'imagerie à semi-conducteur selon l'une quelconque des revendications 1 à 3, dans lequel une rugosité de surface (Ra) du film de protection contre la lumière est comprise dans la plage allant de 15 510 Å à 58 700 Å.

**5.** Film de protection contre la lumière pour un dispositif d'imagerie à semi-conducteur selon l'une quelconque des revendications 1 à 4, dans lequel le matériau dispersé comprend le noir de titane.

**6.** Film de protection contre la lumière pour un dispositif d'imagerie à semi-conducteur selon l'une quelconque des revendications 1 à 5, dans lequel le matériau dispersé comprend du noir de titane et des atomes de Si, et le rapport en teneur (Si/Ti) des atomes de Si aux atomes de Ti dans le matériau dispersé est de 0,20 à 0,50.

**7.** Film de protection contre la lumière pour un dispositif d'imagerie à semi-conducteur selon l'une quelconque des revendications 1 à 6, dans lequel l'initiateur de polymérisation (C) est un composé ester d'oxime.

**8.** Film de protection contre la lumière pour un dispositif d'imagerie à semi-conducteur selon l'une quelconque des revendications 1 à 7, dans lequel l'initiateur de polymérisation (C) est l'éthanone 1-[9-éthyl-6-(2-méthylbenzyl)-9H-carbazol-3-yl]-1-(O-acétyl-oxime).

**9.** Procédé de production d'un film de protection contre la lumière pour un dispositif d'imagerie à semi-conducteur, le dispositif d'imagerie à semi-conducteur comprenant, sur au moins une surface d'un substrat de silicium, une unité de dispositif d'imagerie comprenant un élément récepteur de lumière et une paroi (114) formée sur la surface du substrat de silicium sur laquelle l'unité du dispositif d'imagerie est située, le procédé consistant à :

former une couche sensible au rayonnement (18) par pulvérisation, sur une surface du substrat de silicium et sur une surface de la paroi, d'une composition sensible au rayonnement comprenant :

(A) une dispersion de pigment comprenant un matériau dispersé comprenant un pigment noir, 90 % ou plus du matériau dispersé ayant un diamètre de particules de 15 nm à 30 nm ;
(B) un composé polymérisable ; et
(C) un initiateur de polymérisation ; et

exposer la couche sensible au rayonnement à la lumière ;
**caractérisé en ce que**
la viscosité de la composition sensible au rayonnement à 25 °C est de 2 mPa.s à 15 mPa.s et l'angle de pulvérisation dans l'étape de pulvérisation est de 20° à 160° par rapport à un orifice d'éjection d'une buse de pulvérisation.

**10.** Procédé de production d'un film de protection contre la lumière pour un dispositif d'imagerie à semi-conducteur selon la revendication 9, dans lequel un angle de pulvérisation dans l'étape de pulvérisation est de 40° à 120° par rapport à un orifice d'éjection d'une buse de pulvérisation.

**11.** Procédé de production d'un film de protection contre la lumière pour un dispositif d'imagerie à semi-conducteur selon la revendication 9 ou 10, dans lequel une rugosité de surface (Ra) du film de protection contre la lumière est comprise dans la plage allant de 10 000 Å à 70 000 Å.

**12.** Procédé de production d'un film de protection contre la lumière pour un dispositif d'imagerie à semi-conducteur selon l'une quelconque des revendications 9 à 11, dans lequel l'initiateur de polymérisation (C) est un composé ester d'oxime.

**13.** Procédé de production d'un film de protection contre la lumière pour un dispositif d'imagerie à semi-conducteur selon l'une quelconque des revendications 9 à 12, dans lequel l'initiateur de polymérisation (C) est l'éthanone 1-[9-éthyl-6-(2-méthylbenzyl)-9H-carbazol-3-yl]-1-(O-acétyl-oxime).

**14.** Procédé de production d'un film de protection contre la lumière pour un dispositif d'imagerie à semi-conducteur selon l'une quelconque des revendications 9 à 13, dans lequel l'exposition de la couche sensible au rayonnement est un procédé consistant à exposer la couche sensible au rayonnement de manière à obtenir un motif, et le procédé consiste en outre à développer la couche sensible au rayonnement après l'exposition.

**15.** Dispositif d'imagerie à semi-conducteur (100)
comprenant, sur au moins une surface, une unité de dispositif d'imagerie comprenant un élément récepteur de lumière, une paroi formée sur la surface sur laquelle l'unité de dispositif d'imagerie est située, et le film de protection contre la lumière (18) selon l'une quelconque des revendications 1 à 8, formé sur une surface d'un substrat de silicium et sur la paroi.

**16.** Dispositif d'imagerie à semi-conducteur selon la revendication 15, comprenant :

un substrat de silicium comprenant, sur au moins une surface, une unité de dispositif d'imagerie comprenant un élément récepteur de lumière et une paroi formée sur la surface sur laquelle l'unité de dispositif d'imagerie est située ;
un film de protection contre la lumière selon l'une quelconque des revendications 1 à 8 positionné sur une surface sur laquelle l'unité de dispositif d'imagerie du substrat de silicium est située et forme un motif de sorte qu'au moins une partie de l'unité de dispositif d'imagerie est exposée ; et
un film de protection contre la lumière selon l'une quelconque des revendications 1 à 8 formé sur la paroi formée sur la surface sur laquelle l'unité de dispositif d'imagerie est située.

F I G. 1

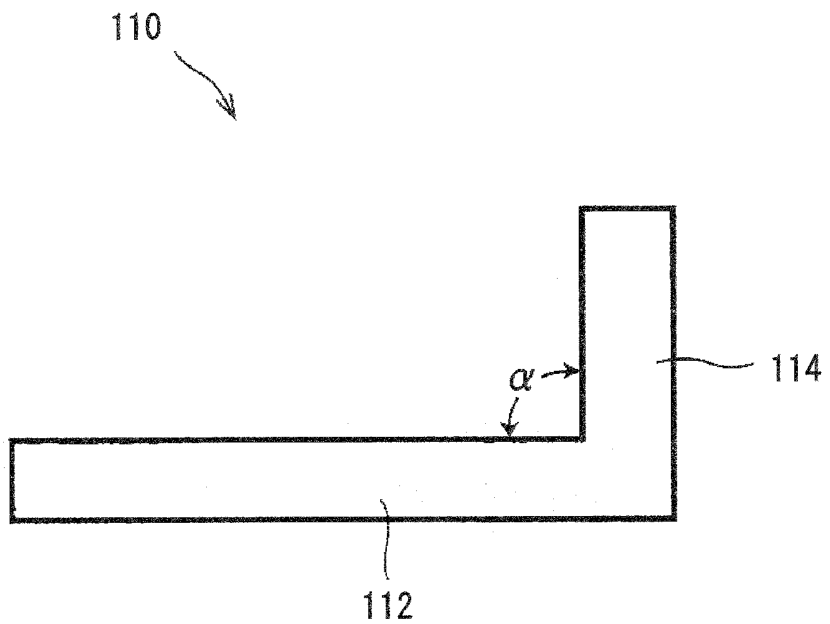


F I G. 2

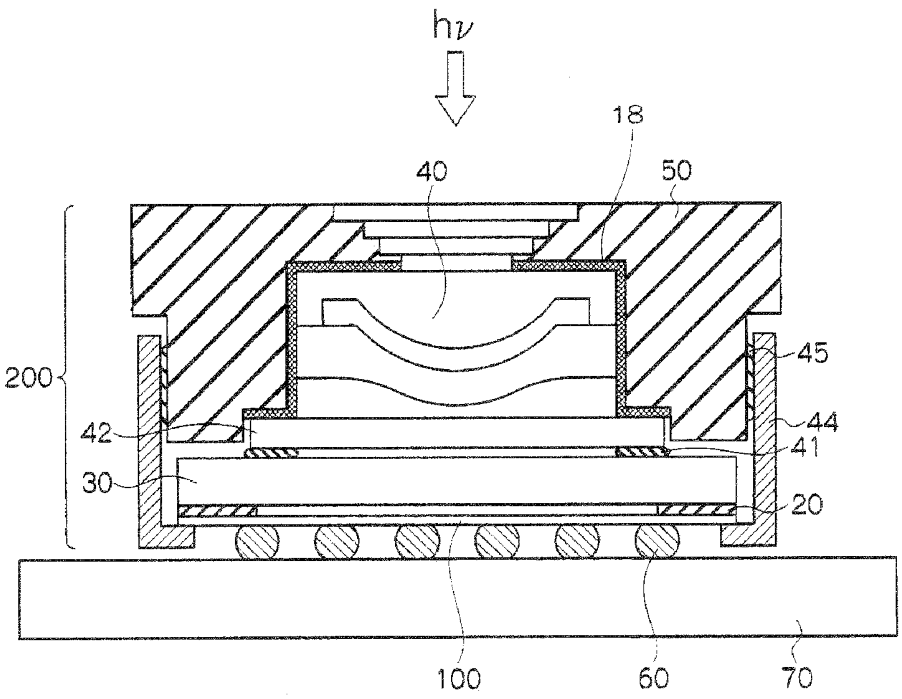

FIG. 3

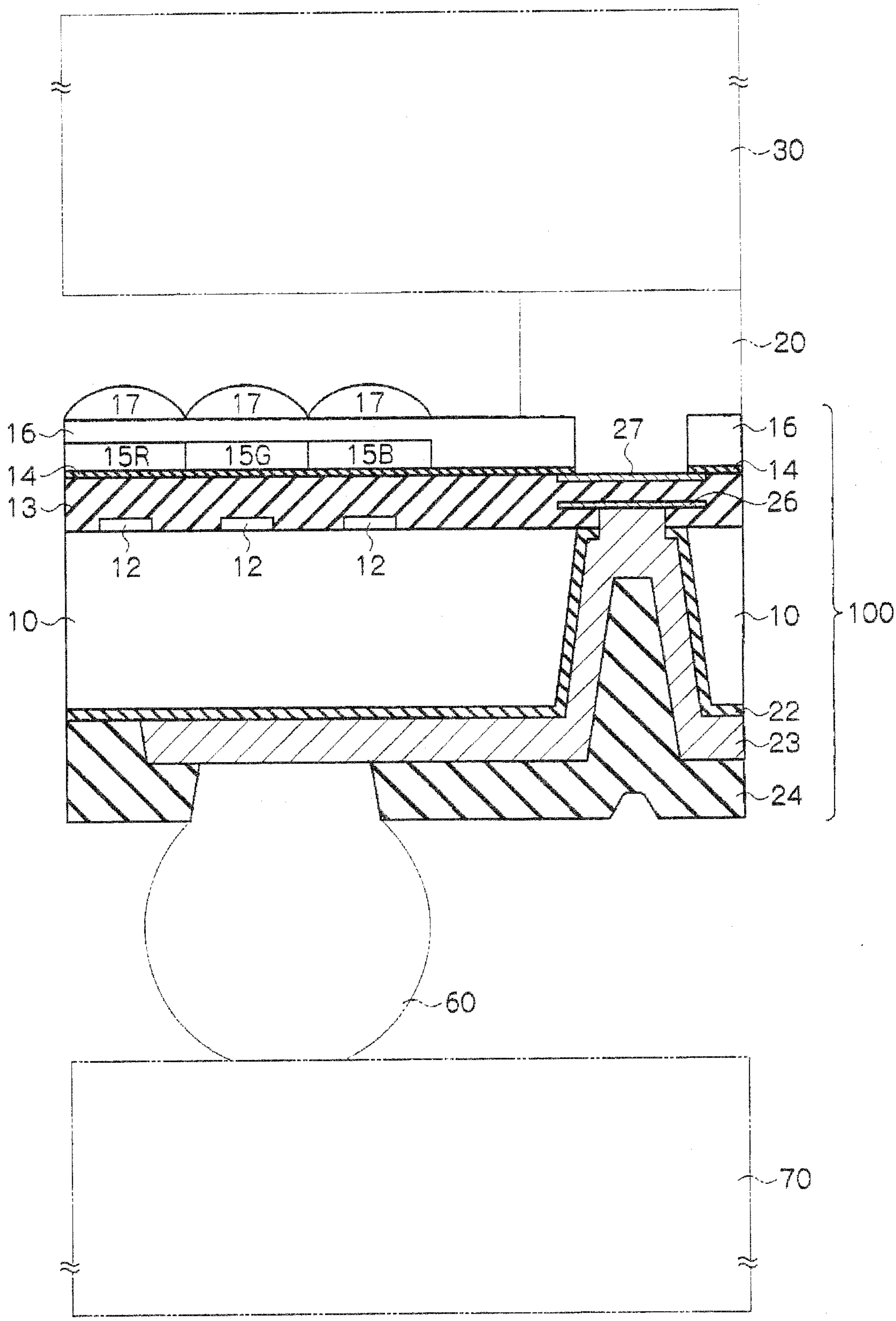
30
20
17
17
17
16
27
16
15R
15G
15B
14
14
13
26
12
12
12
10
10
100
22
23
24
60
70

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3724269 B
- WO 2005037926 A
- JP 2006182627 A
- JP 2006206891 A
- JP 2006209102 A
- JP 2007115921 A
- JP 2010045191 B
- JP 2007302836 A
- JP 49005432 A
- JP 57205322 A
- JP 60065069 A
- JP 61201610 A
- JP 2008026604 A
- JP 48041708 B
- JP 50006034 B
- JP 51037193 A
- JP 48064183 A
- JP 49043191 B
- JP 52030490 B
- JP 10062986 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 2006078749 A
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 10116232 A
- EP 993966 A
- EP 1204000 A
- JP 2001318463 A
- JP 2003262958 A
- JP 2008224982 A
- JP 6490403 A
- JP 6491102 A
- JP 1094301 A
- JP 6011614 A
- JP 2592207 B
- US 4808501 A
- US 5667920 A
- US 5059500 A
- JP 5333207 A
- JP 6035183 A
- JP 6051115 A
- JP 6194828 A
- JP 8211599 A
- JP 4249549 A
- JP 10123316 A
- JP 11302283 A
- JP 7286107 A
- JP 2001004823 A
- JP 8015522 A
- JP 8029771 A
- JP 8146215 A
- JP 11343437 A
- JP 8062416 A
- JP 2002014220 A
- JP 2002014221 A
- JP 2002014222 A
- JP 2002014223 A
- JP 8302224 A
- JP 8073758 A
- JP 8179120 A
- JP 8151531 A
- JP 2008214395 A
- JP 2009099591 A
- JP 2009158863 A


### Non-patent literature cited in the description


- *Nihon Secchaku Kyoukaishi,* vol. 20 (7), 300-308

- Reinforcement of CMOS image sensor business by self-manufacture of CMOS camera module for cellular phones. Toshiba Corporation New Release, 01 October 2007